# EUROPEAN PATENT SPECIFICATION

(11) **EP 4 531 091 B1**
(45) Date of publication and mention of the grant of the patent: **05.08.2026**
(21) Application number: 24186090.7
(22) Date of filing: 02.07.2024
(51) Int. Cl.: H10W 70/63, H10W 70/692, H10W 70/685

(54) **GLASS CORE PROTECTION USING PERIPHERAL BUFFER LAYERS**
GLASKERNSCHUTZ MIT PERIPHEREN PUFFERSCHICHTEN
PROTECTION DE NOYAU DE VERRE À L'AIDE DE COUCHES TAMPONS PÉRIPHÉRIQUES

(30) Priority: 29.09.2023 US 202318374937
(43) Date of publication of application: 02.04.2025
(73) Proprietor: INTEL Corporation, Santa Clara, CA 95054 (US)
(72) Inventor: DANI, Ashay, Chandler, 85248 (US); BAI, Yiqun, Chandler, 85249 (US); GOKHALE, Shripad, Gilbert, 85298 (US); LI, Yonggang Yong, Chandler, 85248 (US); XU, Dingying, Chandler, 85248 (US); SENEVIRATNE, Dilan, Phoenix, 85048 (US); CETEGEN, Edvin, Chandler, 85226 (US); GUPTA, Mohit, Chandler, 85249 (US); MARIN, Brandon C., Gilbert, 85234 (US); SRINIVASAN, Kartik, Gilbert, 85298 (US); RAMANUJA PIETAMBARAM, Srinivas Venkata, Chandler, 95249 (US); FENG, Hongxia, Chandler, 85249 (US); DUAN, Gang, Chandler, 85248 (US); HAN, Jung Kyu, Chandler, 85226 (US); STACEY, Joshua, Chandler, 85286 (US); HEATON, Thomas, Gilbert, 85234 (US); GAMBA, Jason, Gilbert, 85298 (US); GUO, Xiaoying, Chandler, 85248 (US); HAEHN, Nicholas, Scottsdale, 85251 (US); JONES, Jesse, Chandler, 85248 (US); KONG, Jieying, Chandler, 85249 (US); ECTON, Jeremy, Gilbert, 85298 (US); JIMENEZ, Andrew, Mesa, 85210 (US); TANAKA, Hiroki, GILBERT, 85295 (US); MCREE, Robin, Chandler, 85286 (US); BRYKS, Whitney, Chandler, 85249 (US); LIN, Ziyin, Chandler, 85226 (US); NIE, Bai, Chandler, 85249 (US); CHEN, Haobo, Chandler, 85249 (US); MO, Jianyong, Chandler, 85226 (US); ARRINGTON, Kyle, GILBERT, 85297 (US); VEHONSKY, Jacob, Chandler, 85224 (US); WATSON, MAKOYI, Phoenix, 85044 (US); GARELICK, Aaron, Chandler, 85226 (US); SHAN, Bohan, Chandler, 85226 (US); KAYA, Mine, Scottsdale, 85226 (US); WAIMIN, Jose, Chandler, 85226 (US); XIE, Zhixin, Chandler, 85249 (US); LI, Yi, Chandler, 85225 (US); MOHAMMADIGHALENI, Mahdi, Phoenix, 85048 (US); LI, Yuqin, Chandler, 85226 (US); LAI, Shuqi, Phoenix, 85045 (US); CHEN, Shaojiang, Gilbert, 85297 (US); SONG, Hanyu, Chandler, 85226 (US); MU, Bin, Tempe, 85284 (US); TRIPATHI, Astitva, Mesa, 85212 (US); CARRAZZONE, Ryan, Chandler, 85226 (US); WANG, Yekan, Chandler, 85286 (US); SREERAMAGIRI, Praveen, Gilbert, 85297 (US); EL KHATIB, Ibrahim, Chandler, 85226 (US); AJAMI, Hassan, Chandler, 85249 (US); PAGE, Mitchell, Seattle, 98107 (US)
(74) Representative: HGF

(56) References cited:
- US-A1- 2010 108 361
- US-A1- 2014 015 121
- US-A1- 2016 135 289
- US-A1- 2019 164 862

## Description

### BACKGROUND

As semiconductor packaging architectures continue towards more complex and more compact systems, new material solutions may be used to enable such architectures. One promising candidate for use in packaging substrates is a glass core layer. In such substrates, a glass core is sandwiched between overlying and underlying buildup layers. Electrically conductive vias are provided through the glass core in order to provide electrical coupling between the overlying and underlying buildup layers. Glass cores are beneficial because they can provide high density vias. Glass is also a high modulus material, which provides desirable stiffness to the overall package substrate.

However, manufacturing process flows have not been developed to enable high yielding packages in conjunction with glass core solutions. With traditional organic cores, multiple units are fabricated in parallel in a panel structure. After completion, the units are singulated from each other. For example, a saw can be used to singulate the units. This includes passing the saw blade through the glass core. Unfortunately, cracks and other defects are generated when a saw is used to singulate a glass core.

US2010/0108361 A1 relates to a wiring substrate including a substrate body with first and second surfaces on opposite sides and a substrate side surface. US2014/0015121 A1 relates to a wiring substrate including a core substrate made of glass, having first and second surfaces on opposite sides and a side surface between the first surface and the second surface. US2016/0135289 A1 relates to a printed circuit board and a method of manufacturing the same. US2019/0164862 A1 relates to a semiconductor package including a core member, a semiconductor chip, an encapsulant and a connection member

### BRIEF DESCRIPTION OF THE DRAWINGS

Figure 1A is a perspective view illustration of a glass core with a buffer layer surrounding a perimeter of the glass core, in accordance with an embodiment.
Figure 1B is a perspective view illustration of a glass core with a buffer layer surrounding all surfaces of the glass core, in accordance with an embodiment.
Figure 2A is a cross-sectional illustration of a package substrate with a glass core that includes a buffer layer on sidewalls of the glass core, in accordance with an embodiment.
Figure 2B is a cross-sectional illustration of a package substrate with a glass core that includes a buffer layer that conforms to a non-vertical sidewall of the glass core, in accordance with an embodiment.
Figure 2C is a cross-sectional illustration of a package substrate with a glass core that includes a buffer layer that conforms to a sloped sidewall of the glass core, in accordance with an embodiment.
Figure 2D is a cross-sectional illustration of a package substrate with a glass core that includes a buffer layer that wraps around edges of the glass core, in accordance with an embodiment.
Figure 2E is a cross-sectional illustration of a package substrate with a glass core that includes a buffer layer that completely surrounds the glass core, in accordance with an embodiment.
Figure 2F is a cross-sectional illustration of a package substrate with a buffer layer that is mechanically anchored to the glass core, in accordance with an embodiment.
Figure 3A is a cross-sectional illustration of a panel with glass cores that are separated by saw streets that are filled with a buffer layer, in accordance with an embodiment.
Figure 3B is a cross-sectional illustration of a glass core with a buffer layer around a perimeter of the glass core, in accordance with an embodiment.
Figure 3C is a plan view illustration of a panel with a plurality of glass core units that are separated by a saw streets filled with a buffer layer, in accordance with an embodiment.
Figure 3D is a plan view illustration of a unit that includes non-uniform glass cores surrounded by a buffer layer, in accordance with an embodiment.
Figure 3E is a cross-sectional illustration of a glass core that includes a plurality of glass layers, in accordance with an embodiment.
Figures 4A - 4J are cross-sectional illustrations depicting processes for forming package substrates with a glass core that is surrounded by a buffer layer, in accordance with an embodiment.
Figure 5A is a cross-sectional illustration of a panel with a plurality of glass core layers and stacked saw streets filled with a buffer layer, in accordance with an embodiment.
Figure 5B is a cross-sectional illustration of a package substrate with stacked glass cores surrounded by a buffer layer, in accordance with an embodiment.
Figures 6A - 6I are cross-sectional illustrations depicting a process for forming a package substrate with a glass core and a buffer layer that wraps around edges of the glass core, in accordance with an embodiment.
Figures 7A - 7I are cross-sectional illustrations depicting a process for forming a package substrate with a glass core and a buffer layer that surrounds the entirety of the glass core, in accordance with an embodiment.
Figures 8A - 8E are cross-sectional illustrations of panels with glass cores embedded in two or more buffer layers with different configurations, in accordance with an embodiment.
Figures 9A - 9F are illustrations depicting a process for forming a package substrate with a buffer layer that is mechanically anchored to the glass core, in accordance with an embodiment.
Figures 10A - 10K are cross-sectional illustrations depicting a process for forming a package substrate with a glass core that is surrounded by a buffer layer, in accordance with an embodiment.
Figures 11A - 11I are cross-sectional illustrations depicting a process for forming a package substrate with a glass core that is completely surrounded by a buffer layer, in accordance with an embodiment.
Figures 12A - 12G are cross-sectional illustrations depicting a process for forming a package substrate with a glass core that is embedded within a buffer layer, in accordance with an embodiment.
Figure 13 is a schematic of a computing device built in accordance with an embodiment.

### EMBODIMENTS OF THE PRESENT DISCLOSURE

Described herein are electronic systems, and more particularly, glass cores with peripheral buffer layers for electronics packaging, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

As noted above, enabling glass core based package substrates has substantial benefits for the electronics packaging industry. However, certain hurdles still need to be overcome in order to enable high yielding, robust, and relatively low cost solutions. One particular issue is the tendency for the glass cores to develop defects that can lead to cracking, fracturing, and the like. Particularly, these defects may arise out of the singulation process typically used for panel level manufacturing of individual units.

Accordingly, embodiments disclosed herein include panel level architectures where the glass material in saw streets between units is replaced with a buffer material. Cutting buffer materials (e.g., molding material, epoxy, organic buildup film, metallic material, etc.) with traditional singulation processes generates fewer defects. This is because the glass edge surface of the core is protected from the forces induced during singulation. As such, large scale fabrication and assembly (e.g., at the panel level) can be implemented to generate high yielding glass core package substrates.

As will be described in greater detail below, the buffer layers can have various configurations with respect to the glass core. In some embodiments, the buffer layer is a ring that surrounds an outer perimeter of the glass core. In other embodiments, the buffer layer wraps around the edges of the glass core. In yet another embodiment, the buffer layer is over the top surface, the bottom surface, and the sidewall surfaces of the glass core.

Embodiments may also include different manufacturing flows in order to produce glass core package substrate units. In some embodiments, the existing glass saw streets are removed and replaced with a buffer material. Embodiments may also include forming reconstituted panels. In such instances, the molding material surrounding individual glass core units may be the buffer material. In either approach, the singulation process ultimately cuts through the buffer layer instead of the glass material. As such, defect generation is reduced (or eliminated).

Glass cores described herein may be part of package substrates. A package substrate may include the glass core with buildup layers above and/or below the package substrate. A buffer layer may surround the glass core, and the buildup layers may be over top and/or bottom surfaces of the buffer layer. Due to the singulation process, the outer surface of the buildup layers will be substantially coplanar with the outer surface of the buffer layer. The package substrate may also include one or more dies coupled to the buildup layers.

As used herein, "substantially coplanar" may refer to two surfaces that are coplanar to within any manufacturing tolerance of a tool used to generate the surfaces. For example, in a singulation process, a saw may be used to cut through multiple layers of material. Since a single saw with a single sawing path is used to cut through the multiple layers, the exposed edges of those layers will be substantially coplanar. Substantially coplanar may also refer to two surfaces that are parallel to each other but on planes spaced apart from each other by approximately 3µm or less. Substantially coplanar may also refer to two surfaces that are within approximately 3° of being parallel to each other. As used herein, "approximately" may refer to a range of values within ten percent of the stated value. For example, approximately 100µm may refer to a range between 90µm and 110µm.

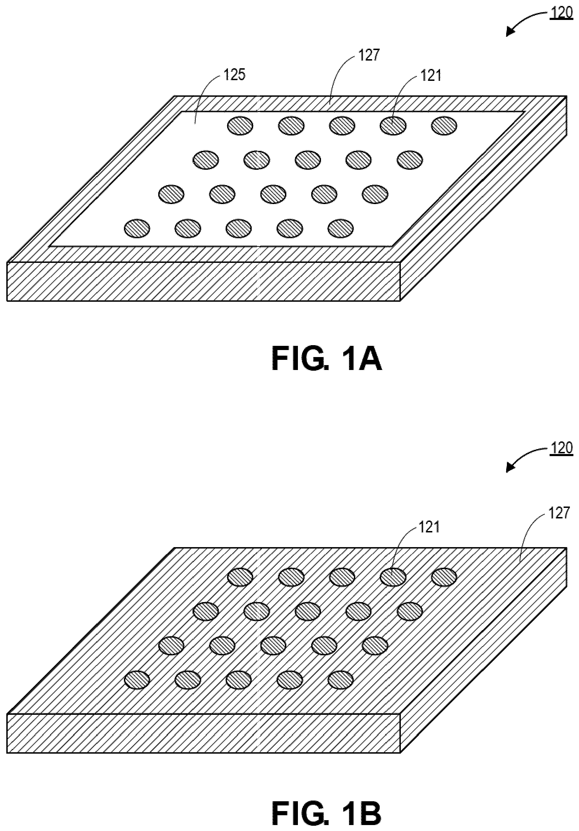

Referring now to Figure 1A, a perspective view illustration of a core assembly 120 is shown, in accordance with an embodiment. The core assembly 120 may comprise a core 125. The core 125 may be a glass layer. In some embodiments, the core 125 may be referred to as a glass core 125. The core 125 may be substantially all glass. It is to be appreciated that a glass core 125 such as those described herein are distinct from traditional organic cores that may include glass fibers for reinforcement. That is, the core 125 may comprise substantially all solid glass.

In an embodiment, the glass core 125 may be substantially all glass. The glass core 125 may be a solid material with an amorphous crystal structure. More particularly, the glass core 125 may be any suitable glass formulation that has the necessary mechanical robustness and compatibility with semiconductor packaging manufacturing and assembly processes. For example, the glass core 125 may comprise aluminosilicate glass, borosilicate glass, alumino-borosilicate glass, silica, fused silica, or the like. In some embodiments, the glass core 125 may include one or more additives, such as, but not limited to, Al₂O₃, B₂O₃, MgO, CaO, SrO, BaO, SnO₂, Na₂O, K₂O, SrO, P₂O₃, ZrO₂, Li₂O, Ti, and Zn. More generally, the glass core 125 may comprise silicon and oxygen, as well as any one or more of aluminum, boron, magnesium, calcium, barium, tin, sodium, potassium, strontium, phosphorus, zirconium, lithium, titanium, and zinc. In an embodiment, the glass core 125 may comprise at least 23 percent silicon (by weight) and at least 26 percent oxygen (by weight). In some embodiments, the glass core 125 may further comprise at least 5 percent aluminum (by weight).

In an embodiment, the glass core 125 may have a thickness (between a top and bottom surface) that is between approximately 50µm and approximately 2,000µm. Though, thinner or thicker glass cores 125 may be used in other embodiments. The glass core 125 may have a substantially rectangular shape (when viewed from above in a plan view). Though, other shapes may also be used for the glass core 125.

In an embodiment, one or more vias 121 may pass through a thickness of the glass core 125. The vias 121 are electrically conductive structures. For example, the vias 121 may comprise a metallic element, such as copper or aluminum. Alloys of multiple metallic elements may also be used in some instances. While shown as a single monolithic structure, it is to be appreciated that the vias 121 may also include seed layers, barrier layers, or any other multi-layer configuration. In Figure 1A, the vias 121 are in direct contact with the glass core 125. In other embodiments, a liner (not shown) may be provided between the glass core 125 and the vias 121. A liner may be a compressible material that aids in decoupling expansion differences between the glass core 125 and the vias due to coefficient of thermal expansion (CTE) mismatch between the glass core 125 and the vias 121.

In an embodiment, the core assembly 120 may also include a buffer layer 127. The buffer layer 127 may surround a perimeter of the glass core 125. The buffer layer 127 may be a ring structure with an inner surface that is in contact with the glass core 125 and an outer surface that faces away from the glass core 125. The buffer layer 127 may have a thickness (between the inner surface and the outer surface) that is between approximately 10µm and approximately 200µm. The thickness of the buffer layer 127 may also be between approximately 10% and approximately 150% of the thickness of the glass core 125. Though, thinner or thicker buffer layers 127 may also be used in some embodiments. The outer surface of the buffer layer 127 may be defined through a singulation process, as will be described in greater detail below. In some embodiments, this results in an outer surface that is substantially orthogonal (i.e., within 5° of being orthogonal) to the top surface of the glass core 125.

The buffer layer 127 may be any material that is compatible with the singulation process (e.g., sawing) used to singulate individual units from a panel. The buffer layer 127 may also include a material that is chosen to have a CTE that is the same as (or close to) the CTE of the glass core 125. The CTE of the buffer layer 127 may be within 20% of the CTE of the glass core 125, or within 5% of the CTE of the glass core 125. In some embodiments, the buffer layer 127 may include materials such as, but not limited to, molding materials, epoxies, organic buildup material, metallic materials, and the like. The buffer layer 127 may be a monolithic material, or the buffer layer 127 may include fillers, such as inorganic filler particles. In an embodiment, the buffer layer 127 may have a first modulus, and the glass core 125 may have a second modulus that is greater than the first modulus.

Referring now to Figure 1B, a perspective view illustration of a core assembly 120 is shown, in accordance with another embodiment. The core assembly may include a glass core (not visible in Figure 1B). The glass core may be surrounded on all sides by the buffer layer 127. That is, the buffer layer 127 may wrap around the perimeter of the glass core, and the buffer layer 127 may be provided over the top surface and bottom surface of the glass core. The vias 121 may be exposed through the buffer layer 127 in order to allow for connections to overlying/underlying layers. In some instances, the buffer layer 127 may wrap around pads over/under the vias 121. In such a configuration, only the pads would be shown through the buffer layer 127.

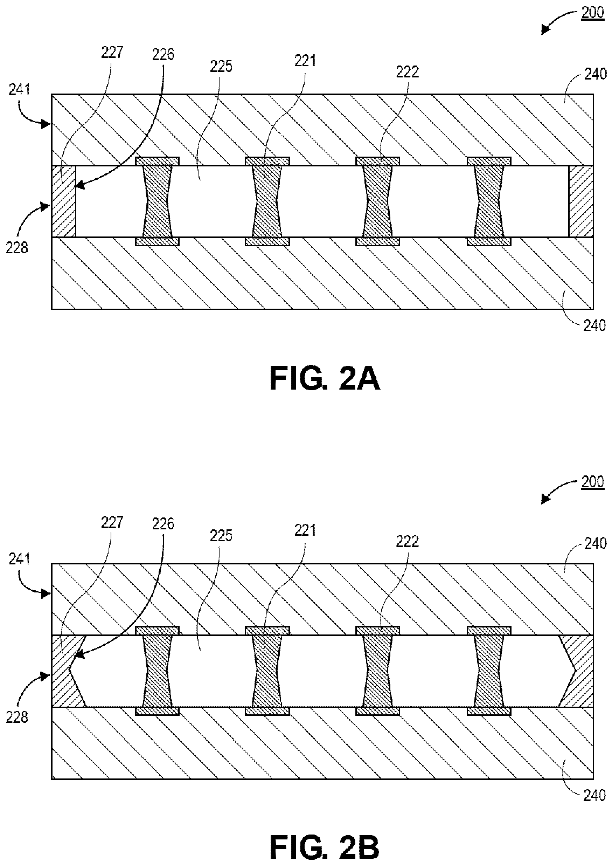

Referring now to Figures 2A - 2F, a series of cross-sectional illustrations depicting package substrates 200 with various architectures is shown, in accordance with an embodiment. For example, the different embodiments depict different interface structures that may appear between the buffer layer 227 and the glass core 225. The different interface structures may be the result of different process flows used to form the package substrates 200. Examples of the different process flows are provided in greater detail below.

Referring now to Figure 2A, a cross-sectional illustration of a package substrate 200 is shown, in accordance with an embodiment. In an embodiment, the package substrate 200 comprises a glass core 225. The glass core 225 may be similar to any of the glass cores described in greater detail herein. Vias 221 may pass through a thickness of the glass core 225. In the illustrated embodiment, the vias 221 have tapered sidewalls. The tapered profile may be the result of a laser assisted etching process. In the particular embodiment shown in Figure 2A, the vias 221 have a double tapered profile to produce an hourglass shaped cross-section for the vias 221. In other embodiments, the vias 221 may have a single taper or no taper at all. Pads 222 may be provided above and/or below each of the vias 221.

In an embodiment, buildup layers 240 may be provided above and below the glass core 225. The buildup layers 240 may comprise an organic buildup film. The buildup film may be provided in laminated layers with electrically conductive features (not shown) embedded therein. For example, traces, vias, pads, and the like may be embedded in the buildup layers 240 using standard packaging assembly processes.

In an embodiment, a buffer layer 227 may be provided along sidewalls 226 of the glass core 225. The buffer layer 227 may be similar to any of the buffer layers described in greater detail herein. For example, the buffer layer 227 may be a mold material, an epoxy, a buildup material, or a metallic material. In some instances, the buffer layer 227 may comprise the same or similar material as the buildup layers 240.

In the illustrated embodiment, the sidewall 226 of the glass core 225 may be substantially vertical. That is, the sidewall 226 may be substantially orthogonal to the top surface of the glass core 225. Similarly, the outer surface 228 of the buffer layer 227 may also be substantially orthogonal to the top surface of the glass core 225. In such an embodiment, the outer surface 228 and the inner surface of the buffer layer 227 may be substantially parallel to each other. In other words, a thickness of the buffer layer 227 (between the outer surface 228 and the sidewall 226 of the glass core 225) may be substantially uniform through a height of the buffer layer 227. The thickness of the buffer layer 227 may be between approximately 10µm and approximately 200µm.

While the left side of the buffer layer 227 and the right side of the buffer layer 227 in Figure 2A illustrate a uniform thickness, embodiments are not so limited. For example, different sidewalls 226 of the glass core 225 may have buffer layer 227 portions with different thicknesses. This may be due, at least in part, to manufacturing tolerances resulting in non-perfect placement of the saw blade during singulation.

In an embodiment, an outer surface 241 of the buildup layers 240 may be substantially coplanar with the outer surface 228 of the buffer layer 227. This can be due to the singulation process used to singulate the package substrate 200 from a panel structure, as will be described in greater detail below. More generally, a width of the buildup layers 240 may be greater than a width of the glass core 225. This allows for the buildup layers 240 to be provided over (or under) both the glass core 225 and the buffer layer 227.

Referring now to Figure 2B, a cross-sectional illustration of a package substrate 200 is shown, in accordance with an additional embodiment. In an embodiment, the package substrate 200 in Figure 2B may be substantially similar to the package substrate 200 in Figure 2A, with the exception of the profile of the sidewalls 226. Instead of being vertical, the sidewalls 226 may have a tapered profiled. For example, the sidewalls 226 in Figure 2B have a first taper and a second taper. The first taper and the second taper may come to a point at a location along a line between the top surface and the bottom surface of the glass core 225. In some embodiments, the point is along a line that is equidistant from the top surface and the bottom surface of the glass core 225. In some instances the point of the sidewall 226 may be at the same height as the height of the minimum diameter point of the vias 221.

The tapered structure of the sidewalls 226 may be the result of a laser assisted patterning process used to singulate the glass core 225 from a larger glass substrate (not shown). Singulating the glass core 225 with a laser assisted etching process may not generate significant defects along the sidewalls 226. The buffer layer 227 is then applied around the glass core 225 (and other glass cores 225) in order to form a reconstituted panel. After buildup layers 240 are added, singulation through the buffer layer 227 can be done using sawing or the like without damaging the glass core 225.

In the embodiment shown in Figure 2B, the outer surface 228 is non-parallel to at least a portion of the inner surface of the buffer layer 227. This is because the inner surface conforms to the shape of the sidewall 226. The resulting shape of the buffer layer 227 can then have a non-uniform thickness through its height. This can lead to a thinner region towards the center of the buffer layer 227 and thicker regions towards the top and bottom of the buffer layer 227.

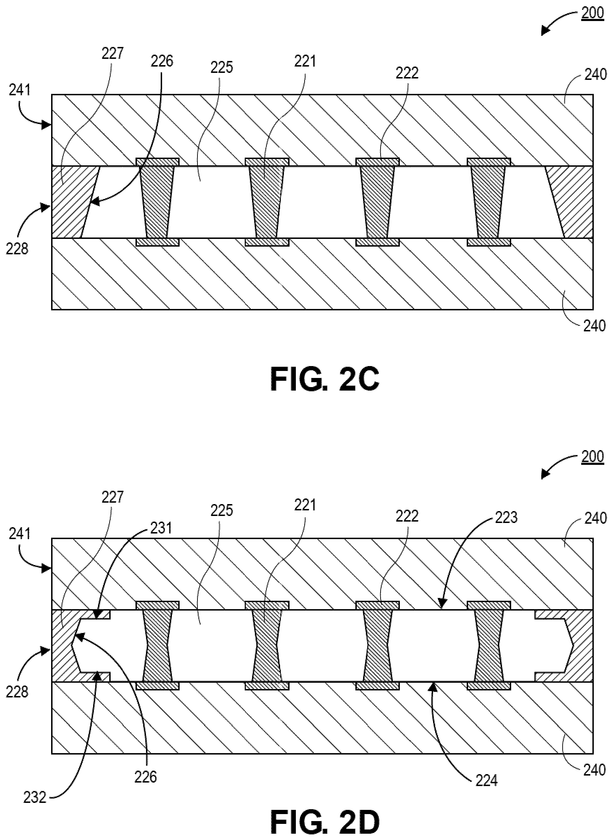

Referring now to Figure 2C, a cross-sectional illustration of a package substrate 200 is shown, in accordance with an additional embodiment. In an embodiment, the package substrate 200 in Figure 2C may be substantially similar to the package substrate 200 in Figure 2B, with the exception of the profile of the sidewalls 226 of the glass core 225. Instead of coming to a point between the top surface and the bottom surface, the sidewalls 226 may have a single sloping (or tapered) profile. A single slope for the sidewalls 226 may be the result of a single sided laser assisted etching process. In contrast, the embodiment shown in Figure 2B may be formed with a double sided laser assisted etching process. A single sided approach may be suitable for thinner glass cores 225. Similarly, the vias 221 may be formed with a single sided etching process. As a result, the vias 221 may also have a single taper.

The sloped sidewalls 226 result in a glass core with a top surface that is narrower than the bottom surface. Of course, the bottom surface may be narrower than the top surface in other arrangements. Since the buffer layer 227 conforms to the sidewalls 226, the buffer layer 227 may also have an inner surface with a single taper. The inner surface may be non-parallel to the outer surface 228.

Referring now to Figure 2D, a cross-sectional illustration of a package substrate 200 is shown, in accordance with an additional embodiment. The package substrate in Figure 2D may be substantially similar to the package substrate 200 in Figure 2B, with the exception of the structure of the buffer layer 227. Instead of being only in contact with the sidewalls 226 of the glass core 225, the buffer layer 227 wraps around the edges of the glass core 225. As such, the buffer layer 227 is provided over top and bottom portions of the glass core 225.

The glass core 225 may have a top surface 223 and a bottom surface 224. The top surface 223 may include a first recessed surface 231. The first recessed surface 231 may be provided around a perimeter of the glass core 225. Similarly, the bottom surface 224 may have a second recessed surface 232 around a perimeter of the glass core 225. The first recessed surface 231 and the second recessed surface 232 may be offset from the top surface 223 and the bottom surface 224, respectively, by up to approximately 20µm. Though, larger offsets may also be used in some embodiments.

In an embodiment, the buffer layer 227 may cover the recessed surfaces 231 and 232 to form a "C-like" shape around the edge surface of the glass core 225. Additionally, the top surface of the buffer layer 227 may still be substantially coplanar with the top surface 223, and the bottom surface of the buffer layer 227 may be substantially coplanar with the bottom surface 224. Providing additional surface area for the contact between the buffer layer 225 and the glass core 225 can increase the adhesion strength and can improve reliability.

In the illustrated embodiment, the sidewalls 226 of the glass core 225 have a double tapered profile. Though, embodiments may include a C-like shaped buffer layer 227 using substantially vertical sidewalls 226 or through the use of a single tapered sidewall 226 profile, similar to embodiments described in greater detail above.

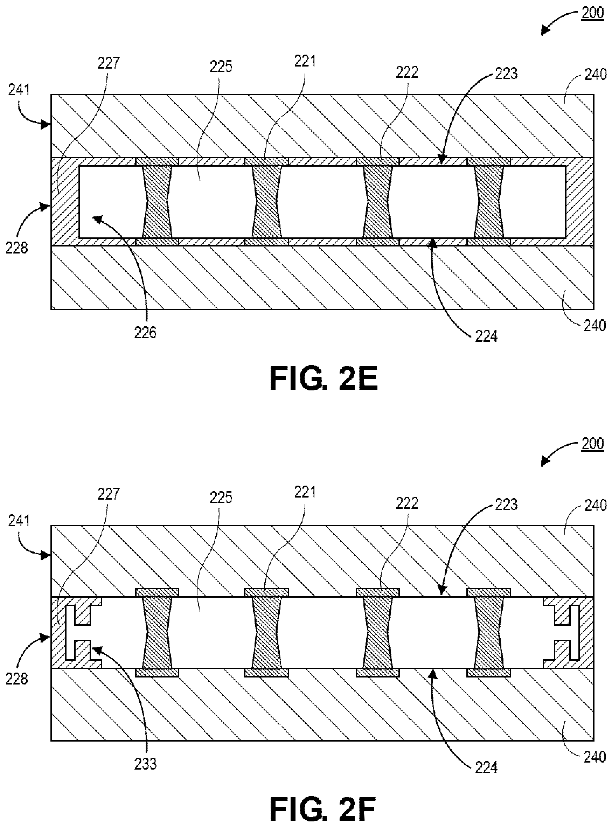

Referring now to Figure 2E, a cross-sectional illustration of a package substrate 200 is shown, in accordance with an additional embodiment. In an embodiment, the package substrate 200 in Figure 2E may be substantially similar to the package substrate 200 in Figure 2A, with the exception of the structure of the buffer layer 227. Instead of only being provided along sidewalls 226, the buffer layer 227 is provided over all surfaces of the glass core 225. For example, the sidewalls 226, the top surface 223, and the bottom surface 224 may be contacted by the buffer layer 227. In some instances, the glass core 225 may be considered as being embedded in the buffer layer 227. In an embodiment, the buffer layer 227 may wrap around the sidewalls of the pads 222 over and/or under the vias 221.

In an embodiment, the thickness of the buffer layer 227 may be non-uniform between the different surfaces of the glass core 225 that are covered. For example, the buffer layer 227 over the sidewalls 226 may be thicker than the buffer layer 227 over the top surface 223 and/or the bottom surface 224. Additionally, the buffer layer 227 over the top surface 223 may be a different thickness than the buffer layer 227 over the bottom surface 224.

The embedded structure of the glass core 225 may result in the buildup layers 240 being spaced away from the glass core 225. For example, the buffer layer 227 may separate the glass core 225 from the buildup layers 240. That is, the buffer layer 227 is between the glass core 225 and the buildup layers 240 in some embodiments. The addition of a buffer layer 227 between the glass core 225 and the buildup layers 240 may result in some reduction in the transfer of stress from the buildup layers 240 into the glass core 225.

In Figure 2E, the profile of the sidewalls 226 is substantially vertical. In other embodiments, the sidewalls 226 may have any profile, such as those described in greater detail herein. In such instances, the buffer layer 227 will conform to the non-vertical profile. This may result in the buffer layer 227 having an outer surface that is a rectangular prism and an inner surface that is an irregular threedimension shape.

Referring now to Figure 2F, a cross-sectional illustration of a package substrate 200 is shown, in accordance with an additional embodiment. The package substrate 200 in Figure 2F may be similar to the package substrate 200 in Figure 2A, with the exception of the profile of the sidewalls of the glass core 225. Instead of having a vertical profile or a tapered profile, the sidewalls of the glass core 225 have an interlocking profile. One notch 233 is or more notches 223 provided into the top surface 223 and/or the bottom surface 224 of the glass core 225. In the invention the buffer layer 227 then fills the notches 233. Providing notches 233 further enhances the mechanical coupling between the buffer layer 227 and the glass core 225. This can improve the reliability of the package substrate 200.

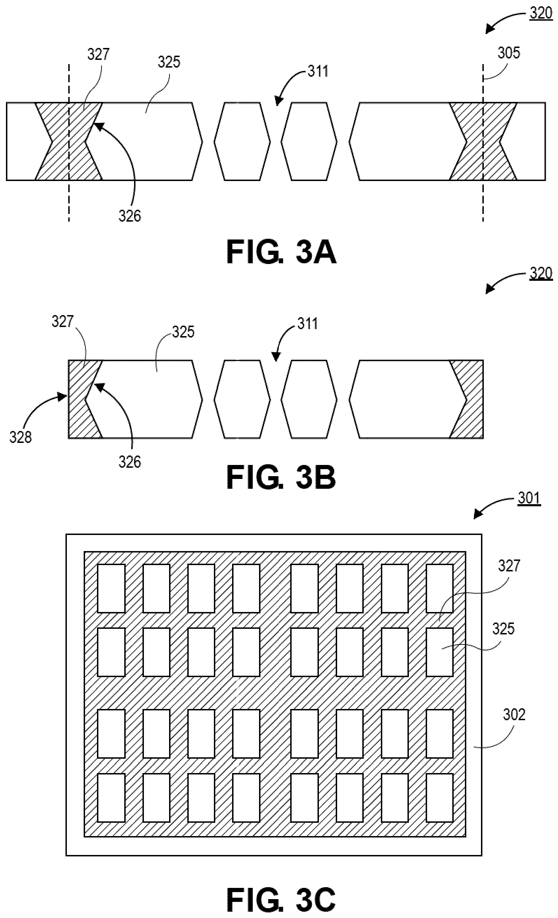

Referring now to Figures 3A and 3B, cross-sectional illustrations of a core assembly 320 is shown, in accordance with an embodiment. In Figure 3A the core assembly 320 is illustrated in a panel form, and in Figure 3B the core assembly 320 is illustrated in a unit form after singulation.

Referring now to Figure 3A, a cross-sectional illustration of a core assembly 320 is shown, in accordance with an embodiment. In an embodiment, the core assembly 320 may comprise a glass core 325. The glass core 325 may be part of a panel structure. That is, a plurality of individual glass cores 325 may be coupled together in a larger panel structure. This allows for more efficient assembly and fabrication processes. In the illustrated embodiment, a full glass core 325 is shown at the center (i.e., between saw streets 305) and partial glass cores 325 are shown outside of the saw streets 305.

The glass core 325 may have any suitable glass formulation and structure, similar to any of the glass cores described in greater detail herein. In an embodiment, one or more via openings 311 may be provided through a thickness of the glass core 325. The via openings 311 may be formed with any suitable patterning process. For example, a laser assisted etching process may be used in some embodiments. As such, the via openings 311 may have tapered sidewalls or the like.

In an embodiment, a perimeter of the glass core 325 may be surrounded by a buffer layer 327. The buffer layer 327 may mechanically couple the multiple glass core 325 units together. In an embodiment, the buffer layer 327 may also have tapered sidewalls. For example, the sidewall 326 of the glass core 325 may have a double taper that comes to a point, and the buffer layer 327 may conform to the profile of the sidewalls 326. The buffer layer 327 may have a material composition similar to any buffer layer described in greater detail herein. The saw streets 305 may be oriented so that they pass through the buffer layer 327. Accordingly, the singulation process will not require any cutting or dicing through the glass material of the glass core 325. This helps reduce the generation of cracks or other defects along the sidewalls 326.

Referring now to Figure 3B, a cross-sectional illustration of a core assembly 320 after singulation is shown, in accordance with an embodiment. In the illustrated embodiment, the glass core 325 is singulated without overlying buildup layers or the like. Though, additional structures, including the buildup layers, vias in the via openings 311, and the like, may be provided on the glass core 325 prior to singulation. In an embodiment, the singulation process results in an outer surface 328 of the buffer layer 327 being substantially vertical. That is, the outer surface 328 may be substantially orthogonal to the top surface of the glass core 325 in some embodiments. More generally, the surface of the outer surface 328 may be non-parallel with the sidewall 326 of the glass core 325.

Referring now to Figure 3C, a plan view illustration of a panel 301 with a glass substrate 302 is shown, in accordance with an embodiment. The panel 301 may include a plurality of glass core 325 units. The glass core 325 units may have been singulated (e.g., with a laser assisted etching process) from the glass substrate 302. After singulation, the glass core 325 units may be separated from each other by saw streets that are filled with a buffer layer 327. Accordingly, after additional processing (e.g., including the addition of buildup layers and the like), the glass core 325 units can be singulated again using a mechanical singulation process (e.g., saw) that does not need to pass through glass material.

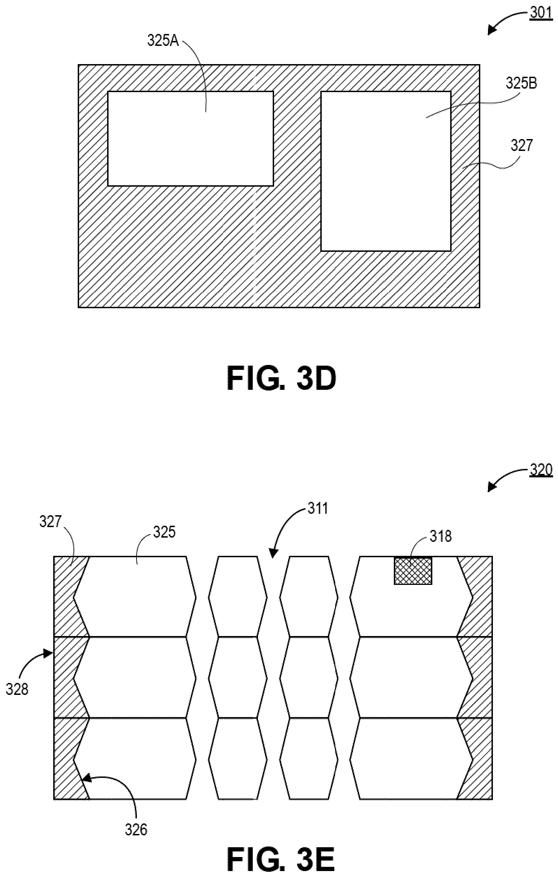

Referring now to Figure 3D, a plan view illustration of a portion of a panel 301 is shown, in accordance with an embodiment. As shown, the portion includes a first glass core region 325A and a second glass core region 325B. The glass core regions 325A and 325B may be surrounded by a buffer layer 327. As shown in Figure 3D, the layout of the glass core regions 325A and 325B need not be uniform or otherwise in a grid-like pattern. Instead, the glass core regions 325A and 325B (and any other number of glass core regions 325) may be provided in locations where the glass core structure is necessary. For example, glass cores 325 may be provided in only regions where high density vias are needed, and the remainder of the core may be a more traditional organic core material.

Referring now to Figure 3E, a cross-sectional illustration of a core assembly 320 is shown, in accordance with an additional embodiment. In an embodiment, the core assembly 320 may comprise a plurality of glass cores 325 that are stacked on top of each other. For example, three glass cores 325 are shown in Figure 3E. Though, two or more glass cores 325 may be used in other embodiments. In the illustrated embodiment, the glass cores 325 are directly in contact with each other. In other embodiments, an adhesive or the like may be provided at the interface between glass cores 325 to improve adhesion. The use of multiple stacked glass cores 325 allows for high aspect ratio via openings 311 to be formed when thick core structures are needed. Each glass core 325 may have an hourglass shaped via opening 311 and those via openings 311 may be aligned. The resulting structure may sometimes be referred to as a via opening with a saw tooth sidewall profile.

In an embodiment, a buffer layer 327 may also be provided around the sidewalls 326 of the glass cores 325. The outer surface 328 of the buffer layer 327 may be substantially vertical due to the singulation process, such as the one described in greater detail above. The inner surface of the buffer layer 327 may conform to the stacked sidewalls 326 of the glass cores 325. In some embodiments, the inner surface of the buffer layer 327 may have a saw tooth profile.

In an embodiment, one or more of the glass cores 325 may have embedded components 318. For example, a single component 318 is shown in Figure 3E. Though, it is to be appreciated that a plurality of components 318 may be provided in a single glass core 325 or in multiple glass core 325 layers. The components 318 may be any suitable component to assist the functionality of a package substrate. In some embodiments, the components 318 are passive components (e.g., capacitors, resistors, inductors, etc.). In other embodiments, the components 318 may be active components.

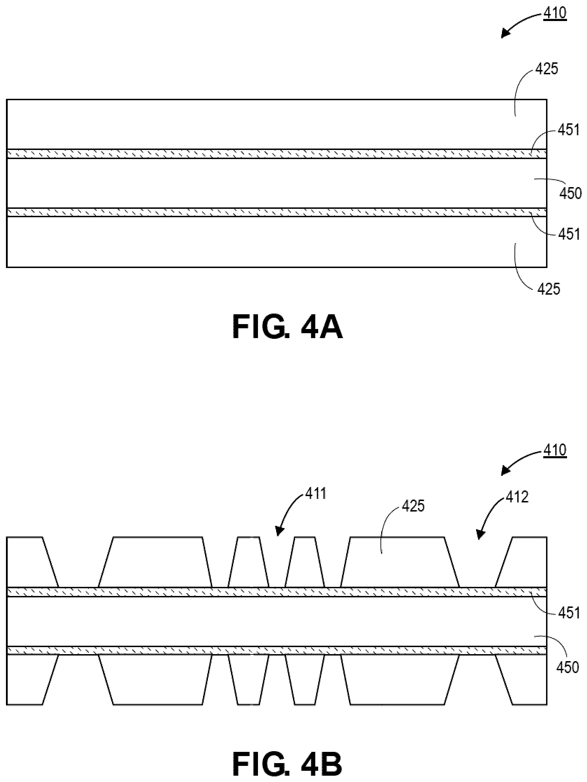

Referring now to Figures 4A - 4J, a series of cross-sectional illustrations depicting a process for forming a package substrate 400 is shown, in accordance with an embodiment. The package substrate 400 may be formed with a glass core 425 that includes a protective buffer layer 427 around an outer perimeter of the glass core 425.

Referring now to Figure 4A, a cross-sectional illustration of a panel 410 at a stage of manufacture is shown, in accordance with an embodiment. In an embodiment, the panel 410 may comprise a carrier 450. The carrier 450 may be a glass carrier, a ceramic carrier, a metallic carrier, or any other suitable material. Glass cores 425 may be attached above and/or below the carrier 450. For example, adhesive layers 451 may attach the glass cores 425 to the carrier 450. The glass cores 425 may be any glass formulation and structure similar to those described in greater detail above.

Referring now to Figure 4B, a cross-sectional illustration of the panel 410 after via openings 411 and buffer openings 412 are formed is shown, in accordance with an embodiment. In an embodiment, the via openings 411 and buffer openings 412 may be formed with a laser assisted etching process. For example, a laser exposure process changes the structure of the glass core 425 and allows for selective etching in order to form the openings 411 and 412. The openings 411 and 412 may have tapered sidewalls in some embodiments. Due to the presence of the carrier 450, the laser assisted etching process may be a single sided process. Accordingly, the sidewalls of the openings 411 and 412 may have a single taper profile with a larger width at the surface and a smaller width proximate to the carrier 450.

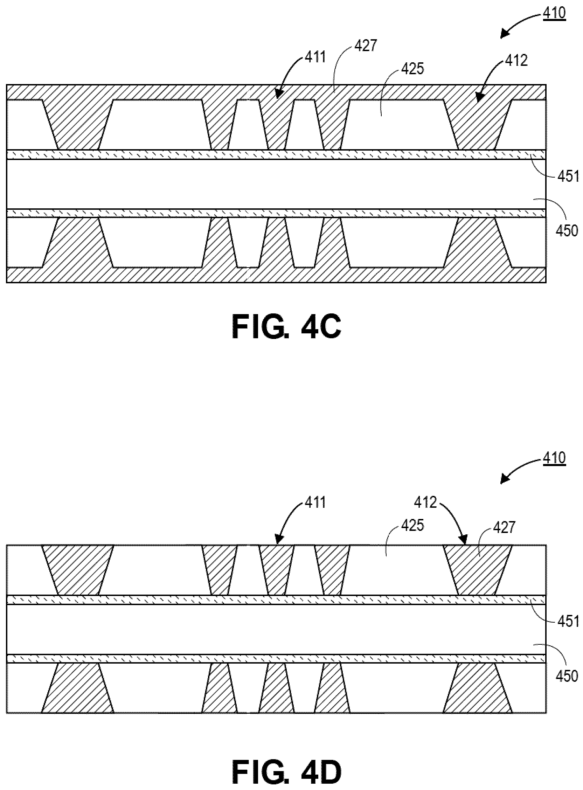

Referring now to Figure 4C, a cross-sectional illustration of the panel 410 after a buffer layer 427 is dispensed is shown, in accordance with an embodiment. The buffer layer 427 may be any material similar to buffer layers described in greater detail herein. In an embodiment, the buffer layer 427 is applied with any suitable process (e.g., spin coating, laminating, molding, chemical vapor deposition (CVD), physical vapor deposition (PVD), or the like). In an embodiment, the buffer layer 427 fills the via openings 411 and the buffer openings 412. The buffer layer 427 may also be disposed over the exposed top/bottom surfaces of the glass cores 425 in some embodiments.

Referring now to Figure 4D, a cross-sectional illustration of the panel 410 after the buffer layer 427 is recessed is shown, in accordance with an embodiment. The recessing process may result in any overburden above the glass cores 425 to be removed. This leaves behind buffer layer 427 material within the via openings 411 and the buffer openings 412.

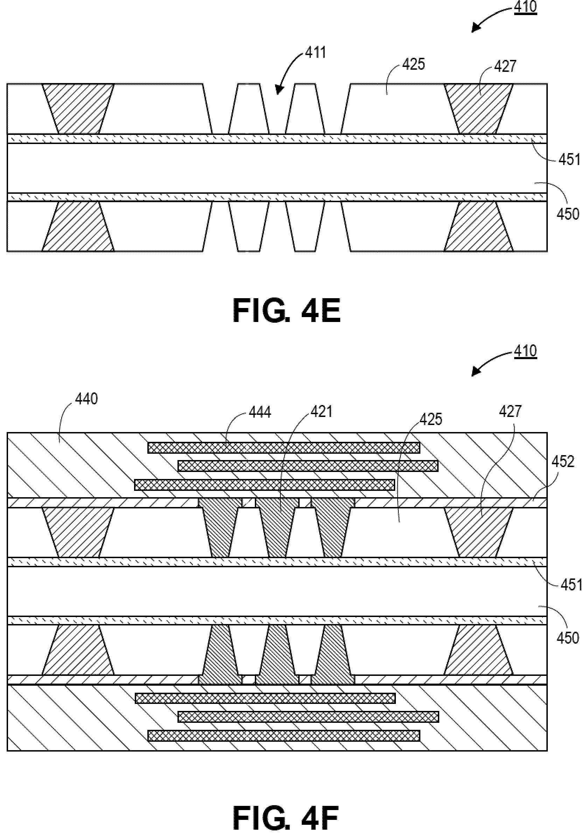

Referring now to Figure 4E, a cross-sectional illustration of the panel 410 after the via openings 411 are cleared is shown, in accordance with an embodiment. In an embodiment, the via openings 411 may be cleared with an etching process. For example, a resist layer may be deposited with an opening over the via openings 411. The buffer openings 412 may remain covered. After the etching process, the resist layer may be removed.

Referring now to Figure 4F, a cross-sectional illustration of the panel 410 after buildup layers 440 are formed is shown, in accordance with an embodiment. In an embodiment, the via openings 411 may be filled with an electrically conductive material to form vias 421. The vias 421 may be formed with an electroplating process or the like. In some embodiments, a liner (not shown) may be provided between the vias 421 and the glass core 425. After the vias 421 are formed a layer 452 may be deposited over the surfaces of the glass cores 425. The layer 452 may be another buffer type material, an adhesive type material, and/or the like.

In an embodiment, buildup layers 440 may be provided over the layer 452. The buildup layers 440 may be organic buildup material, such as buildup film or the like. Multiple buildup film layers may be laminated over each other. Electrically conductive features 444 (such as vias, traces, pads, etc.) may be fabricated within the buildup layers 440 in order to provide necessary electrical routing for the system. The buildup layers 440 may be formed at the panel level. That is, the buildup layers 440 may span across the width of the buffer layers 427.

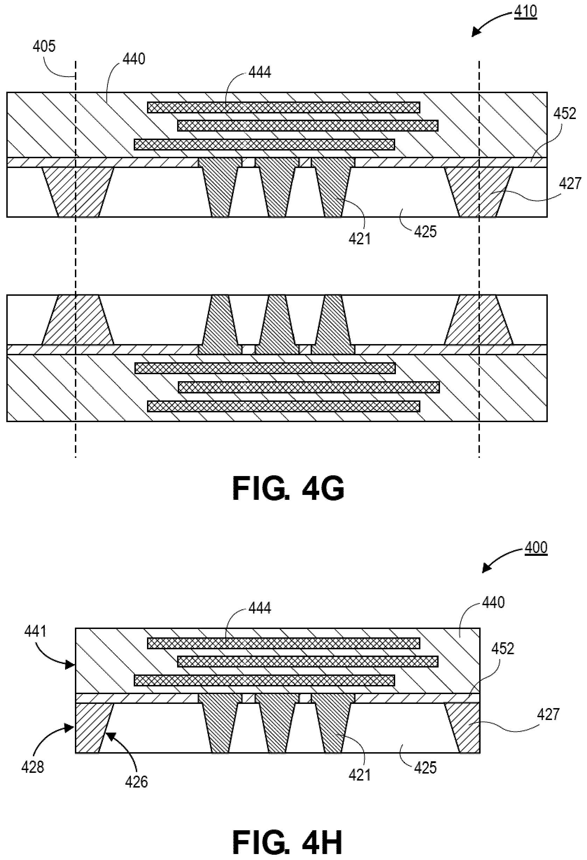

Referring now to Figure 4G, a cross-sectional illustration of the panel 410 after the carrier 450 is removed is shown, in accordance with an embodiment. The carrier 450 and the adhesive layers 451 may be removed with any suitable process. Accordingly, a pair of panels (i.e., top and bottom) are released for further processing on the surfaces that were previously in contact with the carrier 450. As shown in Figure 4G, the saw streets 405 are also illustrated. The saw streets 405 pass through the buildup layers 440 and intersect the buffer layers 427.

Referring now to Figure 4H, a cross-sectional illustration of a package substrate 400 after singulation is shown, in accordance with an embodiment. As shown, the singulation process results in buildup layer 440 and sidewalls 441 being substantially coplanar with an outer surface 428 of the buffer layer 427. In an embodiment, the outer surface 428 of the buffer layer 427 may be non-parallel with an inner surface of the buffer layer 427 that conforms to the sidewall 426 of the glass core 425.

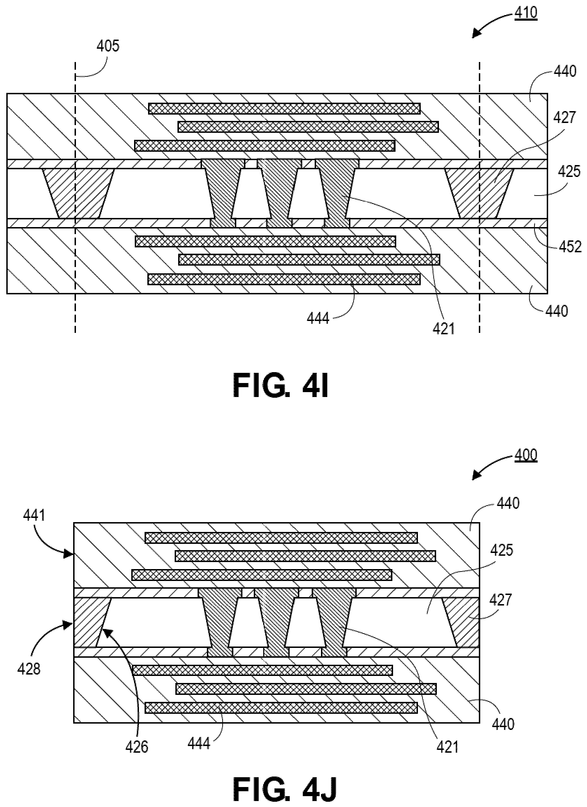

Referring now to Figure 4I, a cross-sectional illustration of a panel 410 is shown, in accordance with an additional embodiment. Instead of singulating the panel 410 after carrier 450 removal, the backside of the glass core 425 is also processed. For example, second buildup layers 440 with electrically conductive features 444 are provided on the opposite side of the glass core 425.

Referring now to Figure 4J, a cross-sectional illustration of a package substrate 400 is shown, in accordance with an additional embodiment. The package substrate 400 in Figure 4J is the result of singulation of the panel 410 in Figure 4I along saw streets 405. As shown, sidewalls 441 of both the top buildup layers 440 and the bottom buildup layers 440 are substantially coplanar with the outer surface 428 of the buffer layer 427.

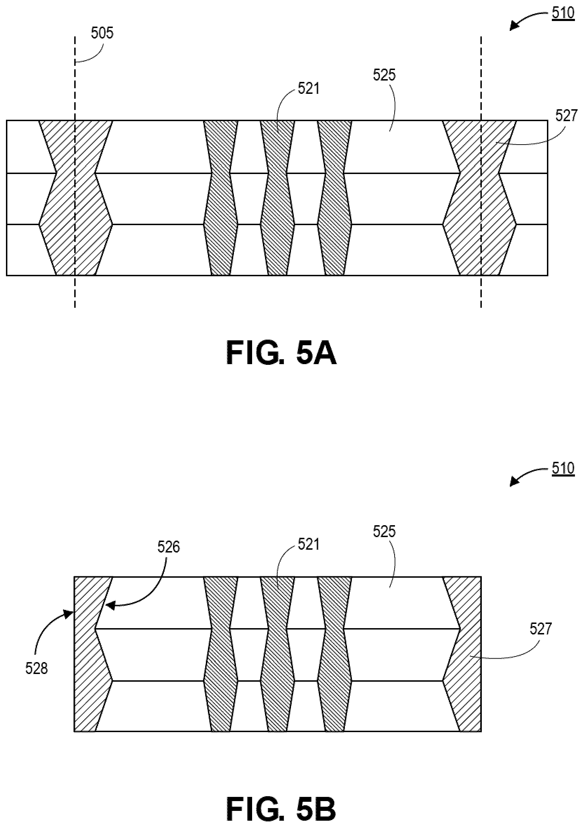

Referring now to Figures 5A and 5B, cross-sectional illustrations depicting the manufacture and singulation of stacked glass cores 525 are shown, in accordance with an embodiment.

Referring now to Figure 5A, a cross-sectional illustration of a panel 510 is shown, in accordance with an embodiment. In an embodiment, the panel 510 may comprise a plurality of stacked glass cores 525. While three glass cores 525 are shown as one example, embodiments may include two or more stacked glass cores 525. The stacked glass cores 525 may be directly contacting each other, or an adhesive layer (not shown) may be provided between the glass cores. Electrically conductive vias 521 with a saw tooth profile may pass through the thicknesses of each of the glass cores 525. Similarly, saw tooth profile buffer layers 527 may pass through the thicknesses of each of the glass cores 525. Saw streets 505 are oriented to pass through an approximate center of the buffer layers 527.

Referring now to Figure 5B, a cross-sectional illustration of a portion of a panel 510 is shown, in accordance with an embodiment. As shown, the outer surfaces 528 of the buffer layer 527 have substantially vertical profiles, while the inner surfaces of the buffer layer 527 have a saw toothed profile that conforms to the sidewalls 526 of the glass cores 525.

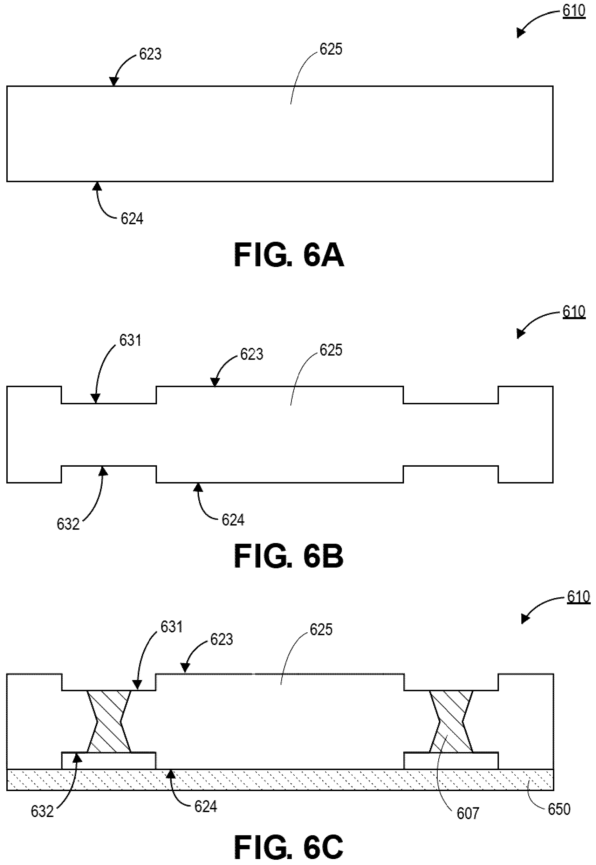

Referring now to Figures 6A - 6I, a series of cross-sectional illustrations depicting a process for forming a package substrate with a buffer layer 627 around a glass core 625 is shown, in accordance with an embodiment. In an embodiment, the buffer layer 627 covers an entire sidewall of the glass core 625 in addition to wrapping around an edge surface of the glass core 625. This can provide enhanced adhesion to improve reliability.

Referring now to Figure 6A, a cross-sectional illustration of a panel 610 is shown, in accordance with an embodiment. In an embodiment, the panel 610 may comprise a glass core 625. The glass core 625 may have a material composition and structure similar to any of the glass cores described in greater detail herein. In an embodiment, the glass core 625 includes a top surface 623 and a bottom surface 624 opposite from the top surface 623. The glass core 625 may have a form factor that is larger than an individual package substrate unit size. That is, a plurality of units can be fabricated from the panel 610.

Referring now to Figure 6B, a cross-sectional illustration of the panel 610 after a first etching process is shown, in accordance with an embodiment. The first etching process may result in the recessing of the top surface 623 and the bottom surface 624. A first recessed surface 631 may be provided into the top surface 623, and a second recessed surface 632 may be provided into the bottom surface 624. The recessed surfaces may be formed with any suitable etching process (e.g., wet etching, dry etching, etc.).

In the illustrated embodiment, sidewalls between the first recessed surface 631 and the top surface 623 may be substantially vertical. Though, other profiles may also be provided depending on the etching process used to form the recesses. Additionally, while the first recessed surface 631 is shown as being substantially parallel to the top surface 623, the first recessed surface 631 may be curved or otherwise non-parallel to the top surface 623. Similarly, the sidewall between the second recessed surface 632 and the bottom surface 624 may be non-vertical, and the second recessed surface 632 may be non-planar or otherwise non-parallel with the bottom surface 624. The first recessed surface 631 may be recessed up to approximately 20µm from the top surface 623. In a particular embodiment, the first recessed surface 631 is recessed up to approximately 5µm from the top surface 623. The second recessed surface 632 may have a similar recess dimension relative to the bottom surface 624.

Referring now to Figure 6C, a cross-sectional illustration of the panel 610 after a carrier 650 is attached is shown, in accordance with an embodiment. The carrier 650 may be any suitable material (e.g., glass, ceramic, metal, etc.). The carrier 650 may be attached to the glass core 625 by an adhesive layer (not shown) in some embodiments.

The glass core 625 may also be exposed with a laser process. The laser exposure may modify regions 607 of the glass core 625 in order to make them more susceptible to an etching chemistry (e.g., a wet etching chemistry). A double sided exposure may be used in some embodiments. In such instances, the laser exposure may be implemented prior to attaching the carrier 650. In other embodiments, a single sided laser exposure may be used.

In an embodiment, the regions 607 may be located within the recesses. That is, the regions 607 may have top surfaces that are on the first recess 631 and bottom surfaces that are on the second recess 632. A width of the regions 607 may be smaller than a width of the recesses as well.

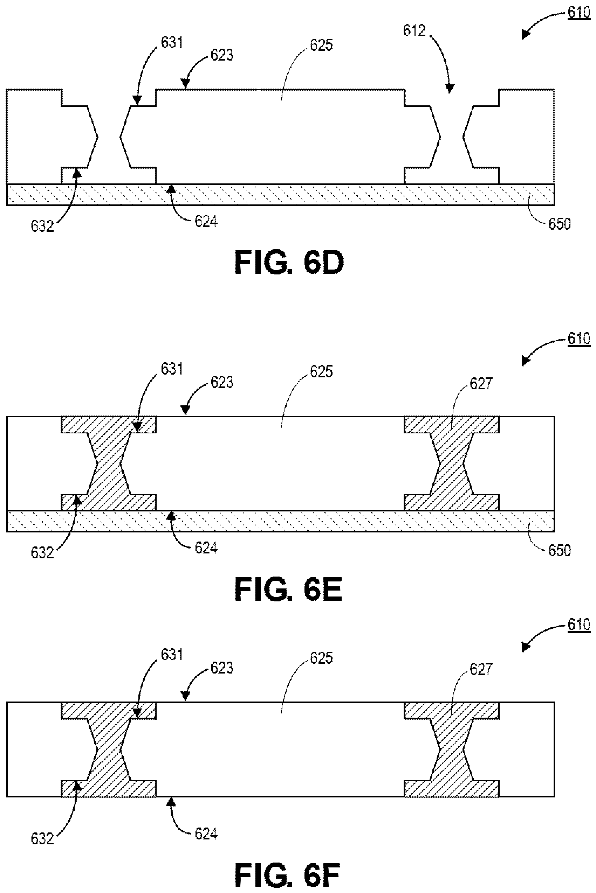

Referring now to Figure 6D, a cross-sectional illustration of the panel 610 after buffer openings 612 are formed is shown, in accordance with an embodiment. In an embodiment, the buffer openings 612 may be formed with an etching process that selectively removes the regions 607. In an embodiment, the buffer openings 612 may have sidewalls that are tapered, as a result of the laser enhanced etching process.

Referring now to Figure 6E, a cross-sectional illustration of the panel 610 after a buffer layer 627 is dispensed in the buffer openings 612 is shown, in accordance with an embodiment. The buffer layer 627 may be any material similar to other buffer layers described in greater detail herein. The buffer layer 627 may be applied with any suitable deposition process (e.g., coating, laminating, molding, CVD, PVD, etc.). Any excess buffer layer 627 may be recessed to expose the top surface 623 of the glass core 625. The buffer layer 627 may contact sidewalls of the glass core 625 and the recessed surfaces 631 and 632. The top of the buffer layer 627 may be substantially coplanar with the top surface 623 and the bottom surface of the buffer layer 627 may be substantially coplanar with the bottom surface 624.

Referring now to Figure 6F, a cross-sectional illustration of the panel 610 after the carrier 650 is removed is shown, in accordance with an embodiment. In an embodiment, the carrier 650 is removed with any suitable process. Any adhesive layer may also be removed and/or cleaned from the bottom surface 624.

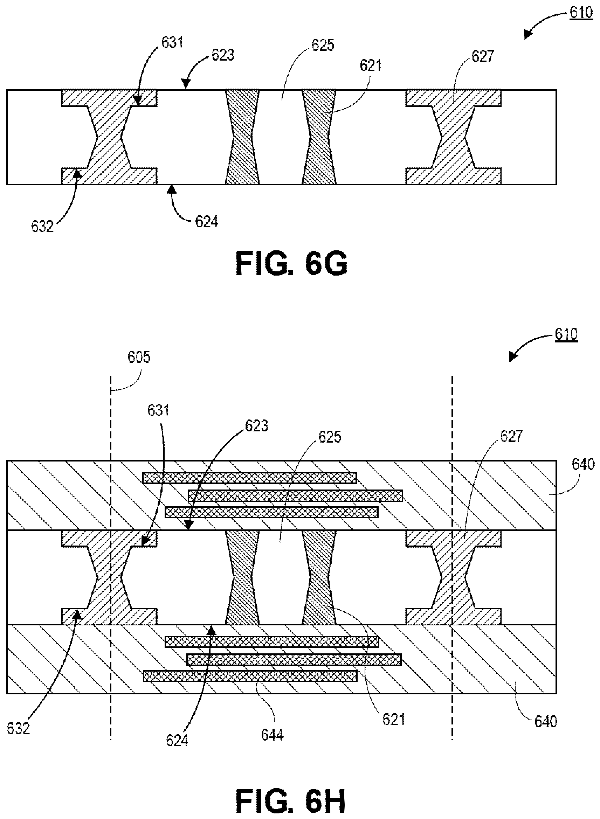

Referring now to Figure 6G, a cross-sectional illustration of the panel 610 after vias 621 are formed is shown, in accordance with an embodiment. In an embodiment, the vias 621 may be electrically conductive vias 621 that pass through a thickness of the glass core 625. A liner (not shown) may be provided between the vias 621 and the glass core 625. The vias 621 may be formed with a laser assisted etching process, followed by an electroplating process. Accordingly, sidewalls of the vias 621 may have a tapered profile. Though, vertical profiles or any other profile may also be possible depending on the manufacturing process used to form the vias 621.

Referring now to Figure 6H, a cross-sectional illustration of the panel 610 after buildup layers 640 are formed above and/or below the glass core 625 is shown, in accordance with an embodiment. In an embodiment, the buildup layers 640 may include laminated organic buildup film or the like. In an embodiment, electrically conductive features 644 (e.g., pads, traces, vias, etc.) may also be fabricated with the buildup layers 640. The buildup layers 640 may extend across the width of the buffer layer 627. As shown in Figure 6H, the saw streets 605 pass through the buildup layers 640 and intersect the buffer layers 627.

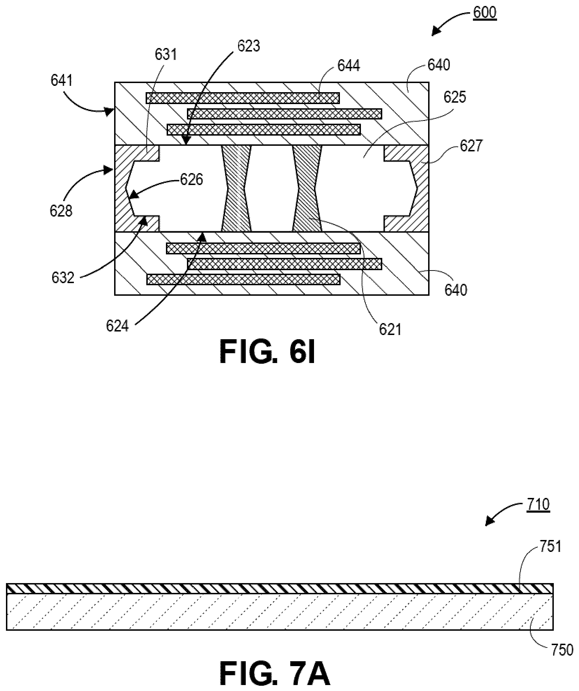

Referring now to Figure 6I, a cross-sectional illustration of a package substrate 600 after singulation is shown, in accordance with an embodiment. The panel 610 may be singulated along the saw streets 605 in order to form individual units of the package substrate 600. As shown, the sidewall 641 of the buildup layers 640 may be substantially coplanar with the outer surface 628 of the buffer layer 627.

In an embodiment, the buffer layer 627 may cover the sidewall 626 of the glass core 625 and wrap around the end regions of the glass core 625. For example, the buffer layer 627 fills the recesses from the top surface 623 and the bottom surface 624. That is, the buffer layer 627 covers the first recess 631 and the second recess 632. This wrapping structure of the buffer layer 627 may be referred to as having a C-shaped structure. That is, the buffer layer 627 may have a vertical component conforming to the sidewall 626 of the glass core 625 and a pair of horizontal components extend away from ends of the vertical component.

Referring now to Figure 7A - 7I, a series of cross-sectional illustrations depicting a process for forming a package substrate 700 with a buffer layer 727 is shown, in accordance with an embodiment. In the illustrated embodiment, the package substrate 700 is fabricated using a reconstituted panel process. That is, known good glass cores 725 are assembled together and overmolded with the buffer layer 727 in order to form the reconstituted panel 710. After buildup layers 740 are added, individual package substrate 700 can be singulated from the panel 710.

Referring now to Figure 7A, a cross-sectional illustration of the panel 710 with a base carrier 750 is shown, in accordance with an embodiment. The carrier 750 may be any suitable material, (e.g., glass, ceramic, metal, etc.). The carrier 750 may have a form factor to accommodate a plurality of glass core 725 units (which are added in a subsequent processing operation). In an embodiment, an adhesive layer 751 is provided over a top surface of the carrier 750.

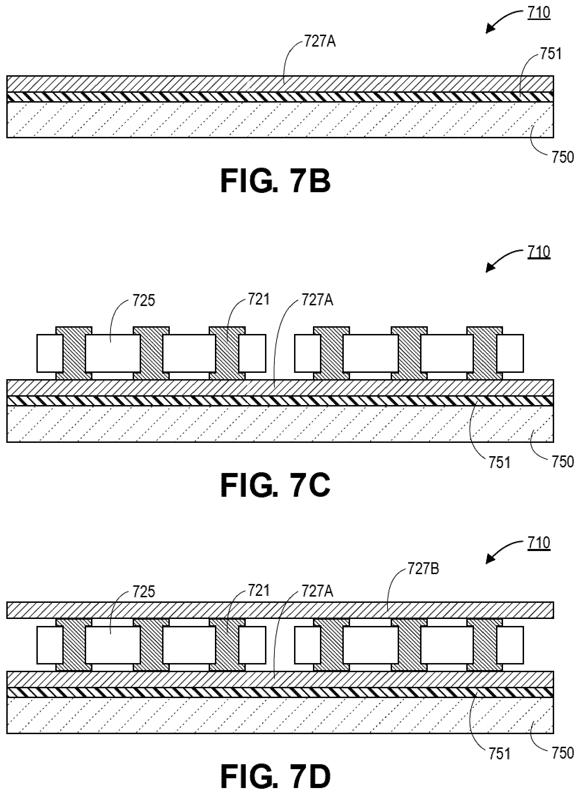

Referring now to Figure 7B, a cross-sectional illustration of the panel 710 after a first portion of the buffer layer 727A is dispensed over the carrier 750 is shown, in accordance with an embodiment. In an embodiment, the first portion of the buffer layer 727A may be deposited with a lamination process, or any other suitable process.

Referring now to Figure 7C, a cross-sectional illustration of the panel 710 after glass cores 725 are placed on the first portion of the buffer layer 727A is shown, in accordance with an embodiment. As shown, the glass cores 725 may be individual units that are placed on the carrier (e.g., with a pick-and-place tool). The glass cores 725 may have electrically conductive vias 721 and pads overlying/underlying the vias 721. In the illustrated embodiment, the glass cores 725 may have vertical sidewalls. Though, in other embodiments, the glass cores 725 have tapered sidewalls.

Referring now to Figure 7D, a cross-sectional illustration of the panel 710 after a second portion of the buffer layer 727B is disposed over the glass cores 725 is shown, in accordance with an embodiment. The second portion of the buffer layer 727B may be dispensed with a lamination process or any other suitable process. In the illustrated embodiment, the first portion of the buffer layer 727A and the second portion of the buffer layer 727B are the same shading to indicate a uniform material composition. In other embodiments, as will be described in greater detail below, the first portion of the buffer layer 727A and the second portion of the buffer layer 727B may have different material compositions.

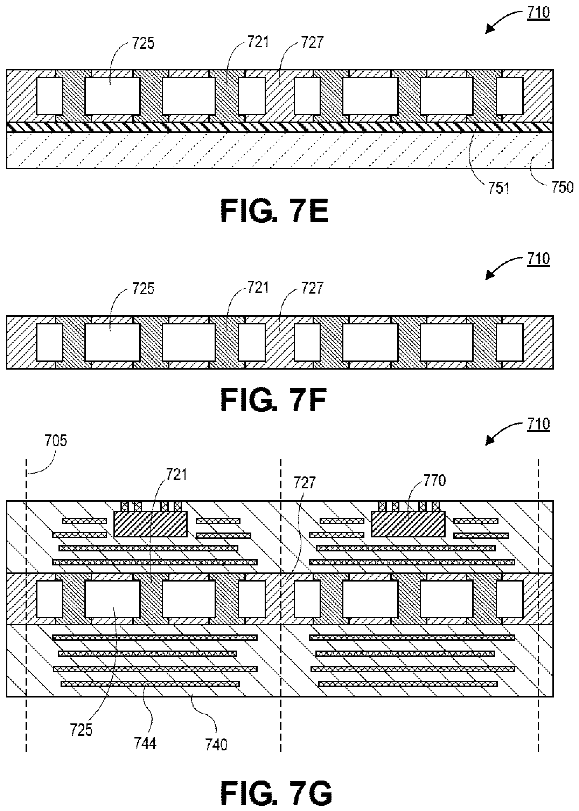

Referring now to Figure 7E, a cross-sectional illustration of the panel 710 after a molding operation is shown, in accordance with an embodiment. For example, a press (not shown) may apply pressure to the second portion of the buffer layer 727B in order to squeeze the first portion of the buffer layer 727A against the second portion of the buffer layer 727B to form a unified buffer layer 727. The buffer layer 727 may fill the gaps between the glass cores 725. Additionally, the buffer layer 727 may wrap around all surfaces of the glass cores 725. That is, the buffer layer 727 may be along sidewalls of the glass cores 725, as well as over the top surface and the bottom surface of the glass cores 725. The buffer layer 727 may wrap around pads over and under the vias 721.

Referring now to Figure 7F, a cross-sectional illustration of the panel 710 after the carrier 750 is removed is shown, in accordance with an embodiment. In an embodiment, the carrier 750 and the adhesive 751 may be removed with any suitable process.

Referring now to Figure 7G, a cross-sectional illustration of the panel 710 after buildup layers 740 are formed is shown, in accordance with an embodiment. In an embodiment, the buildup layers 740 may comprise laminated organic buildup film. Electrically conductive features 744 (e.g., pads, traces, vias, etc.) may also be provided within the buildup layers 740. In some embodiments embedded bridges 770 may also be provided in the buildup layers 740. Bridges 770 may include substrates, such as silicon, that enable high density routing in order to communicatively couple a pair of dies together.

As shown in Figure 7G, saw streets 705 are provided between the glass cores 725. The saw streets 705 pass through the buildup layers 740 and intersect the buffer layer 727. As such, there is no cutting through glass during subsequent singulation processes.

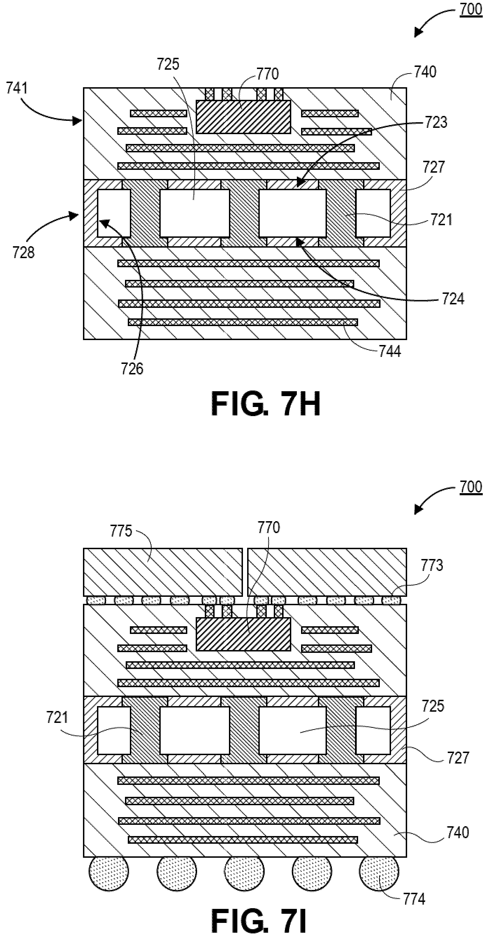

Referring now to Figure 7H, a cross-sectional illustration of a package substrate 700 after singulation is shown, in accordance with an embodiment. Since singulation passes through the buffer layer 727, the outer surface 728 of the buffer layer 727 is substantially coplanar with the outer surface 741 of the buildup layers 740. Depending on the location of the singulation and the spacing between glass cores 725, the thickness of the buffer layer 727 along the sidewalls 726 may be different than the thickness of the buffer layer 727 over the top surface 723 and/or the bottom surface 724 of the glass core 725.

Referring now to Figure 7I, a cross-sectional illustration of the package substrate 700 after dies 775 are attached is shown, in accordance with an embodiment. In an embodiment, the dies 775 may be communicatively coupled to the buildup layers 740 through interconnects 773, such as any first level interconnect (FLI) architecture. The bridge 770 may communicatively couple the two dies 775 together. In some embodiments, second level interconnects (SLIs) 774 are provided below the bottom buildup layers 740. For example, the SLIs 774 may enable connection to a board (e.g., a printed circuit board (PCB)), an interposer, or the like.

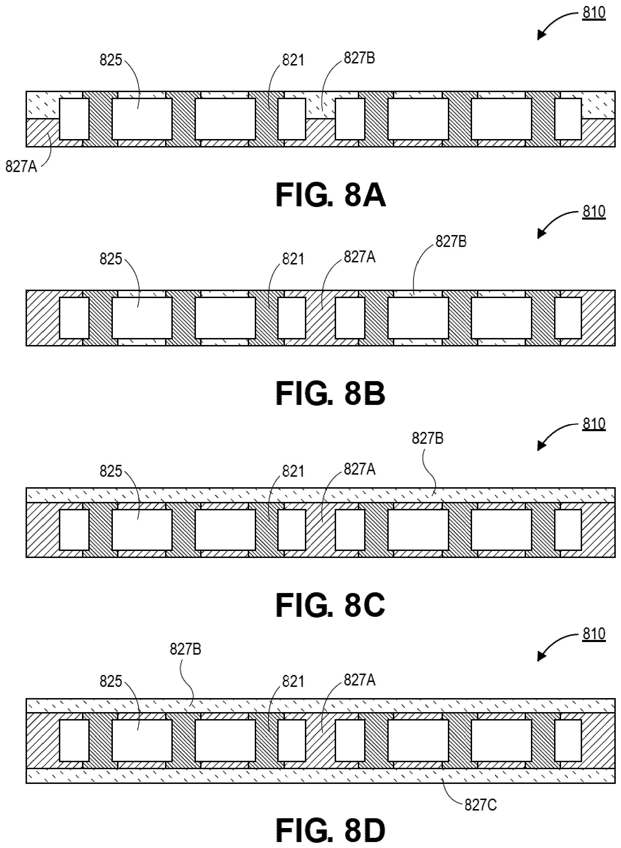

Referring now to Figures 8A-8E, cross-sectional illustrations of reconstituted panels 810 are shown in accordance with additional embodiment. The reconstituted panels 810 include different buffer layer 827 architectures. For example, embodiments illustrate structures with multiple different buffer layer 827 regions.

Referring now to Figure 8A, a cross-sectional illustration of a panel 810 is shown, in accordance with an embodiment. In an embodiment, the panel 810 comprises glass cores 825 with vias 821 that are surrounded by a buffer layer 827. More particularly, the buffer layer 827 comprises a first region 827A and a second region 827B. The first region 827A may have a different material composition than the second region 827B.

In an embodiment, the first region 827A may cover a bottom portion of the glass cores 825, and the second region 827B may cover a top portion of the glass cores 825. The interface between the first region 827A and the second region 827B may be approximately at a midpoint (in the Z-direction) of the glass cores 825. Though, the interface may be higher or lower. That is, the first region 827A and the second region 827B may have different thicknesses in some embodiments.

Referring now to Figure 8B, a cross-sectional illustration of a panel 810 is shown, in accordance with an additional embodiment. As shown, the first region 827A of the buffer layer is between the glass cores 825. Some of the first region 827A may wrap around ends of the glass cores 825. The second region 827B of the buffer layer may be over the top surface and the bottom surface of the glass cores 825. That is, the second region 827B may be surrounded by the first region 827A in some embodiments.

Referring now to Figure 8C, a cross-sectional illustration of a panel 810 is shown, in accordance with an additional embodiment. In the structure of Figure 8C, the first region 827A of the buffer layer surrounds all surfaces of the glass cores 825. The second region 827B of the buffer layer may be provided above the glass cores 825. For example, the second region 827B may not directly contact any portion of the glass cores 825.

Referring now to Figure 8D, a cross-sectional illustration of a panel 810 is shown, in accordance with yet another embodiment. The embodiment shown in Figure 8D is similar to the one in Figure 8C, with the addition of a third region 827C of the buffer layer below the glass cores 825. The third region 827C may be the same material as the second region 827B, or the third region 827C may be a different material than the second region 827B.

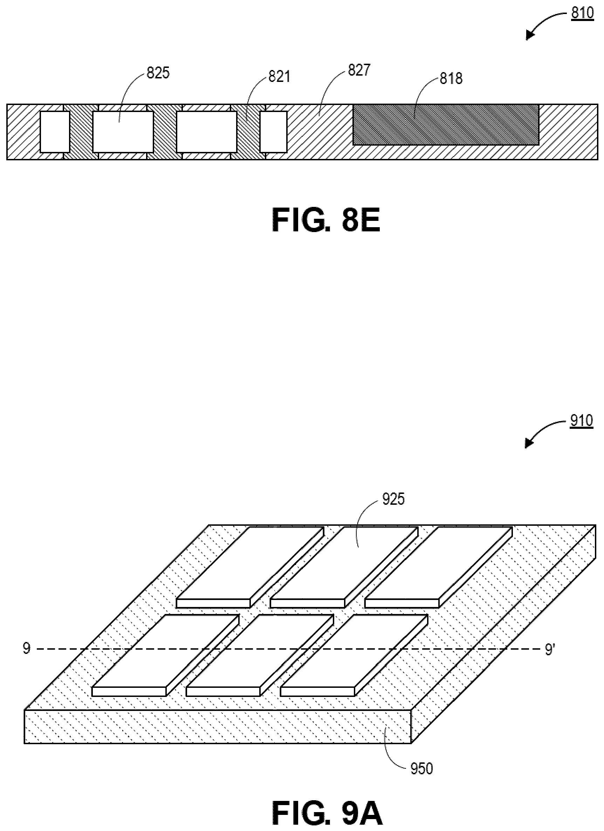

Referring now to Figure 8E, a cross-sectional illustration of a panel 810 is shown, in accordance with an additional embodiment. Instead of having adjacent glass cores 825, a glass core 825 may be adjacent to a component 818. The component 818 may be embedded in the buffer layer 827. The component 818 may be a passive component (e.g., capacitor, inductor, resistor, etc.) or an active component. The component 818 may then be integrated into the core of the package substrate by controlling where the singulation is made. For example, the saw street may be to the right of the component 818 in Figure 8E, and the region between the glass core 825 and the component 818 may be left intact.

Referring now to Figures 9A - 9F a series of illustrations depicting a process for forming a package substrate 900 with a glass core 925 is shown, in accordance with an embodiment. In an embodiment, the glass core 925 may include notching features in order to improve adhesion between the glass core 925 and a buffer layer. The panel level process may also be described as using a reconstituted panel process.

Referring now to Figure 9A, a perspective view illustration of a panel 910 is shown, in accordance with an embodiment. The panel 910 may include a carrier 950 (e.g., comprising glass, ceramic, metal, etc.). The carrier 950 may also include an adhesive (not shown in Figure 9A). In an embodiment, a plurality of glass cores 925 may be placed on the carrier 950. The glass cores 925 may be similar to any of the glass cores described in greater detail herein. In an embodiment, the glass cores 925 may be known good structures that are pick-and-placed onto the carrier 950. As such, a reconstituted panel 910 with high yielding units can be manufactured.

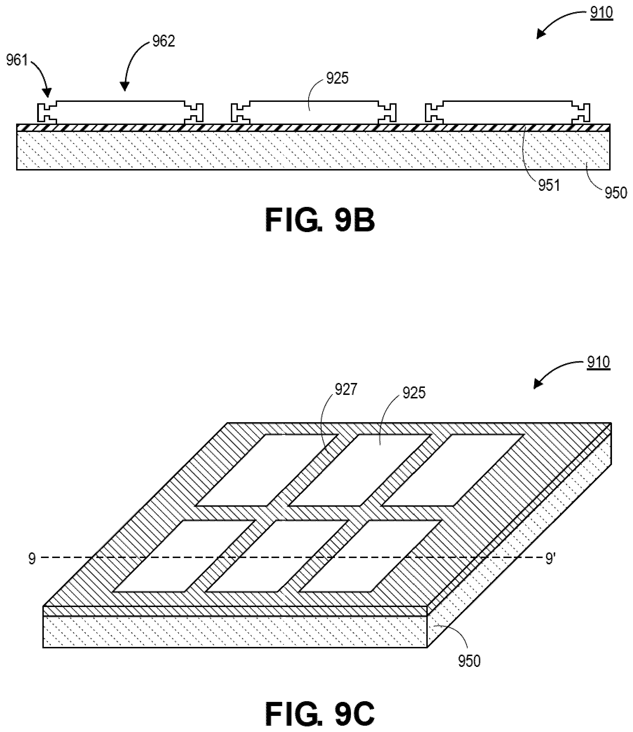

Referring now to Figure 9B, a cross-sectional illustration of the panel 910 in Figure 9A along line 9-9' is shown, in accordance with an embodiment. In an embodiment, the glass cores 925 may be adhered to the carrier 950 by adhesive 951. The adhesive 951 may be a layer (as shown), or the adhesive 951 may be dispensed locally below each glass core 925.

In an embodiment, the glass cores 925 may have a central portion 962 and edge portions 961. In an embodiment, the edge portions 961 may extend up to approximately 200µm or more away from the sidewall of the glass cores 925. The edge portions 961 may have a width between approximately 10µm and approximately 150µm in some embodiments. The edge portions 961 may have a notched structure. The notched structure may be used to improve mechanical adhesion to a buffer layer that is to be added in a subsequent processing operation. The edge portions 961 may be fabricated into the glass cores 925 before the glass cores 925 are placed on the carrier 950.

Referring now to Figure 9C, a perspective view illustration of the panel 910 after a buffer layer 927 is dispensed around the glass cores 925 is shown, in accordance with an embodiment. In an embodiment, the buffer layer 927 may be dispensed with any suitable process. For example, lamination, molding, or the like may be used. The buffer layer 927 may be any material used for buffer layers described in greater detail herein. For example, epoxies, molding materials, buildup material, metallic materials, and the like may be used for the buffer layer 927. In some embodiments, a polishing process may be used to planarize the top surface of the glass cores 925 with the top surface of the buffer layer 927.

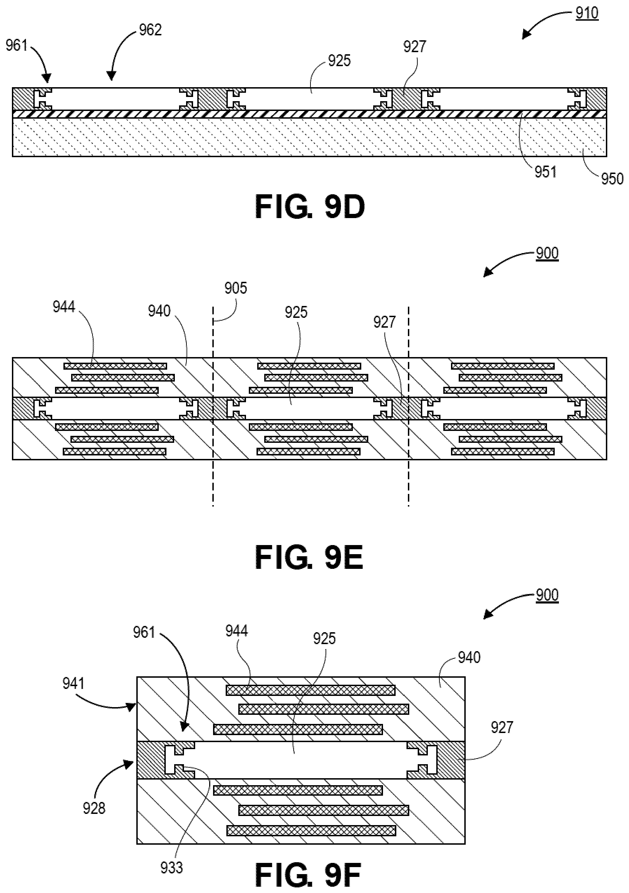

Referring now to Figure 9D, a cross-sectional illustration of the panel 910 in Figure 9C along line 9-9' is shown, in accordance with an embodiment. As shown, the buffer layer 927 wraps around the edge portions 961 of the glass cores 925. The buffer layer 927 may also fill the notches in the edge profile of the glass cores 925 in order to improve mechanical coupling between the buffer layer 927 and the glass cores 925.

Referring now to Figure 9E, a cross-sectional illustration of the panel 910 after the carrier 950 is removed and buildup layers 940 are formed. In an embodiment, the buildup layers 940 may be similar to any of the buildup layers described in greater detail herein. For example, the buildup layers 940 may include electrically conductive features 944 (e.g., pads, traces, vias, etc.). The buildup layers 940 extend across the buffer layers 927. As shown, the saw streets 905 pass through the buildup layers 940 and the buffer layers 927.

Referring now to Figure 9F, a cross-sectional illustration of a package substrate 900 after singulation is shown, in accordance with an embodiment. In an embodiment, the buildup layers 940 have sidewalls 941 that are substantially coplanar with an outer surface 928 of the buffer layer 927. Additionally, the outer surface 928 of the buffer layer 927 is a different shape than the inner surface of the buffer layer 927. For example, one or more notches 933 and the like may be provided along the inner surface, as opposed to a single linear outer surface 928.

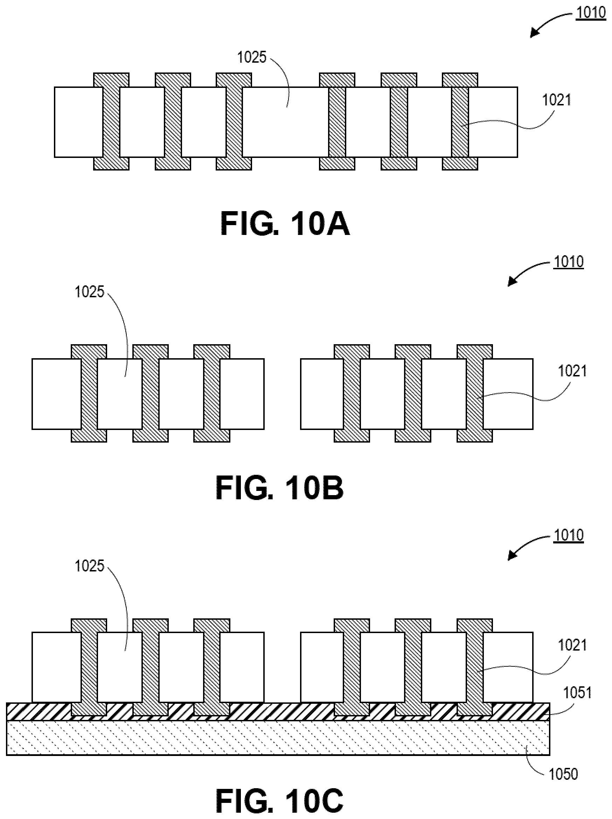

Referring now to Figures 10A - 10K, a series of cross-sectional illustrations depicting a process for forming a package substrate 1000 from a reconstituted panel 1010 is shown, in accordance with an embodiment.

Referring now to Figure 10A, a cross-sectional illustration of a panel 1010 with a glass core 1025 is shown, in accordance with an embodiment. In an embodiment, the panel 1010 includes a plurality of glass core 1025 units that are fabricated on a single glass sheet. The glass cores 1025 may include vias 1021. The vias 1021 may be similar in composition and structure to any via described in greater detail herein. In an embodiment, the panel 1010 may have any glass formulation and thickness similar to embodiments described in greater detail herein.

Referring now to Figure 10B, a cross-sectional illustration of the panel 1010 after singulation of the individual glass core 1025 units is shown, in accordance with an embodiment. In the illustrated embodiment, the singulation depicts glass core 1025 sidewalls that are vertical. However, other embodiments may include tapered or otherwise non-vertical edge profiles. For example, when a laser assisted etching process is used for singulation, the edges of the glass cores 1025 may be sloped.

Referring now to Figure 10C, a cross-sectional illustration of the panel 1010 after the individual glass cores 1025 are placed onto a carrier 1050 is shown, in accordance with an embodiment. In an embodiment, the glass cores 1025 may be known good units. That is, after singulation in Figure 10B, the glass cores 1025 may be tested, with only the fully functional units being placed on the carrier 1050. In some embodiments, an adhesive 1051 may be provided between the glass cores 1025 and the carrier 1050.

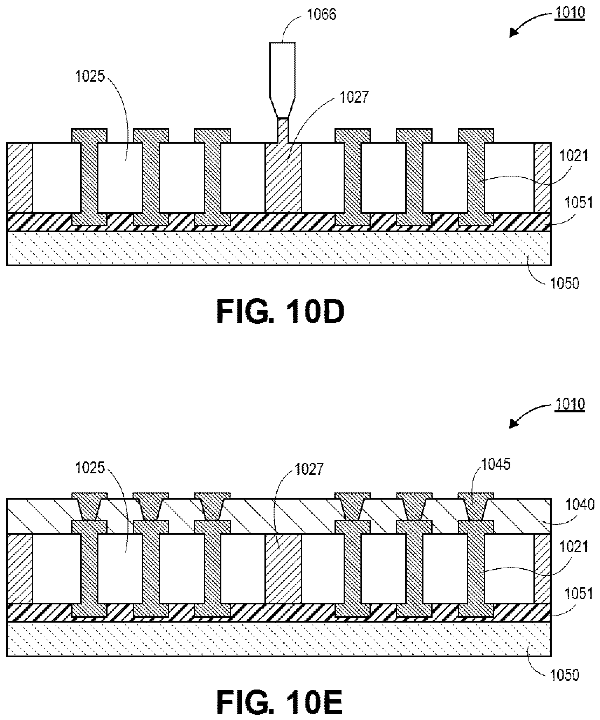

Referring now to Figure 10D, a cross-sectional illustration of the panel 1010 after a buffer layer 1027 is added between the glass cores 1025 is shown, in accordance with an embodiment. In an embodiment, the buffer layer 1027 may be dispensed with a nozzle 1066 or through any other suitable deposition process. The buffer layer 1027 may have a material composition similar to any of the buffer layers described in greater detail herein.

Referring now to Figure 10E, a cross-sectional illustration of the panel 1010 after buildup layers 1040 are formed is shown, in accordance with an embodiment. The buildup layers 1040 may include organic buildup film or the like. Electrically conductive features 1045 (e.g., vias, traces, pads, etc.) may also be provided in the buildup layers 1040.

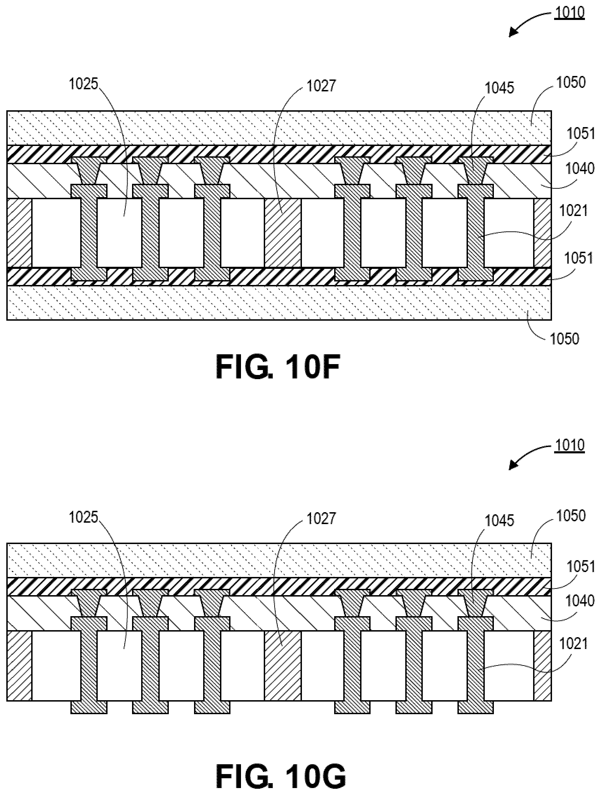

Referring now to Figure 10F, a cross-sectional illustration of the panel 1010 after a second carrier 1050 is attached over the buildup layers 1040 is shown, in accordance with an embodiment. In an embodiment, the second carrier 1050 may be attached with an adhesive 1051 or the like. The second carrier 1050 may be similar to the first carrier 1050 below the glass core 1025. Though different carrier 1050 structures may also be used in some embodiments.

Referring now to Figure 10G, a cross-sectional illustration of the panel 1010 after the first carrier 1050 is removed is shown, in accordance with an embodiment. In an embodiment, removal of the first carrier 1050 exposes the bottom surface of the glass core 1025.

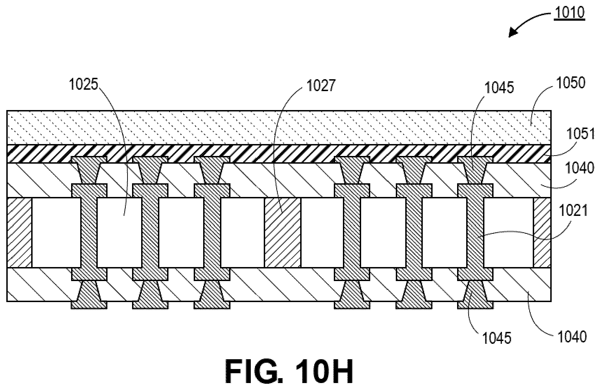

Referring now to Figure 10H, a cross-sectional illustration of the panel 1010 after buildup layers 1040 are formed on the bottom of the glass cores 1025 is shown, in accordance with an embodiment. The buildup layers 1040 may be similar to those formed above the glass core 1025. Electrically conductive features 1045 may also be embedded in the buildup layers 1040 below the glass cores 1025 in some embodiments.

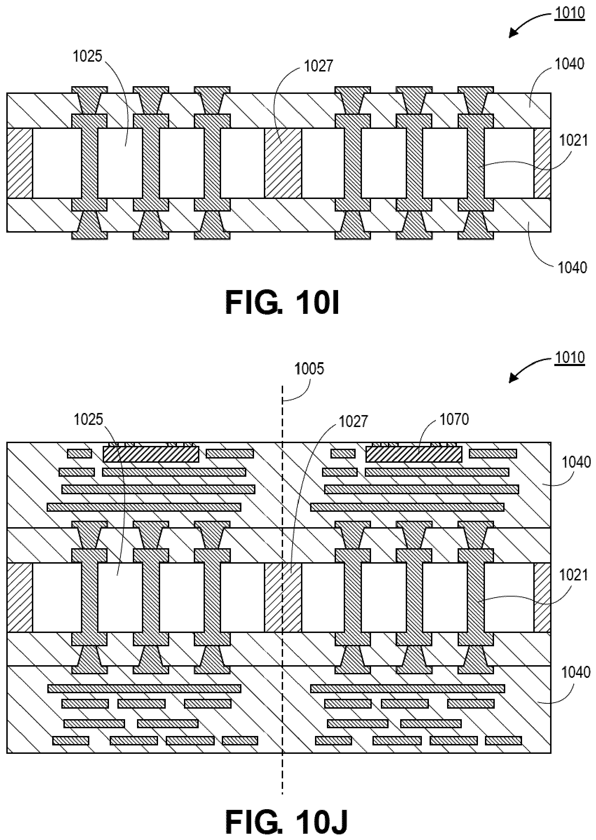

Referring now to Figure 10I, a cross-sectional illustration of the panel 1010 after the second carrier 1050 is removed is shown, in accordance with an embodiment. In an embodiment, the second carrier 1050 may be removed with any suitable process.

Referring now to Figure 10J, a cross-sectional illustration of the panel 1010 after additional buildup layers 1040 are formed is shown, in accordance with an embodiment. In some instances, one or more bridges 1070 may be embedded in the buildup layers 1040. The bridge 1070 may be a silicon bridge 1070 to enable high density routing between dies that will be attached to the singulated package substrate in a subsequent processing operation.

A saw street 1005 is shown in Figure 10J. The saw street 1005 passes through the buildup layers 1040 and intersects the buffer layer 1027. Accordingly, the singulation process will not need to pass through any glass material, and damage to the glass cores 1025 is reduced.

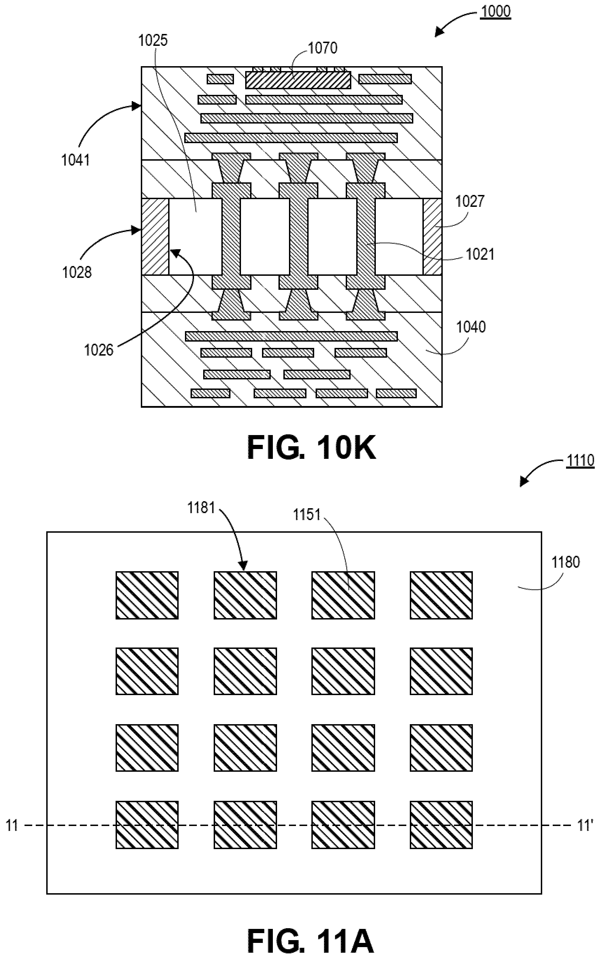

Referring now to Figure 10K, a cross-sectional illustration of a package substrate 1000 after singulation is shown, in accordance with an embodiment. In an embodiment, the package substrate 1000 includes buildup layers 1040 with outer surfaces 1041 that are substantially coplanar with the outer surface 1028 of the buffer layer 1027. In an embodiment, the inner surface of the buffer layer 1027 conforms to the sidewall 1026 of the glass core 1025. In the illustrated embodiment, the sidewall 1026 of the glass core 1025 and the outer surface 1028 of the buffer layer 1027 are substantially parallel. Though, in other embodiments, the outer surface 1028 of the buffer layer 1027 is along a plane that intersects a plane that includes at least a portion of the sidewall 1026.

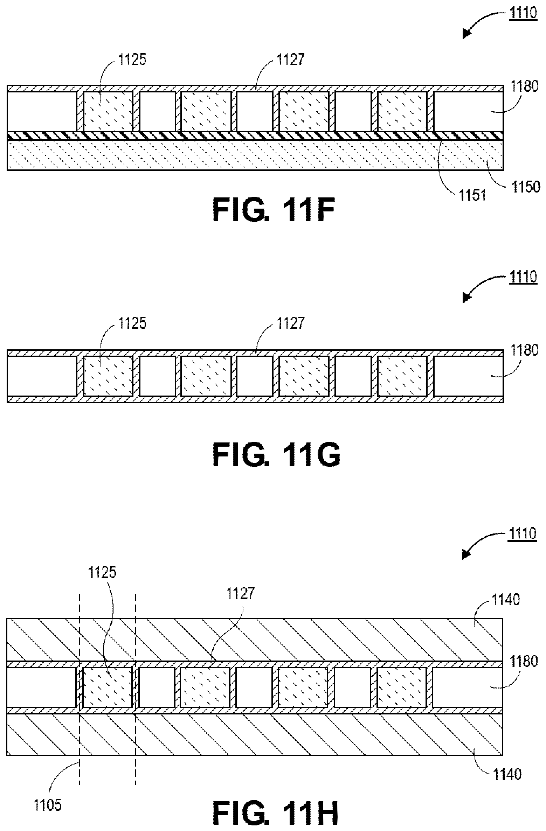

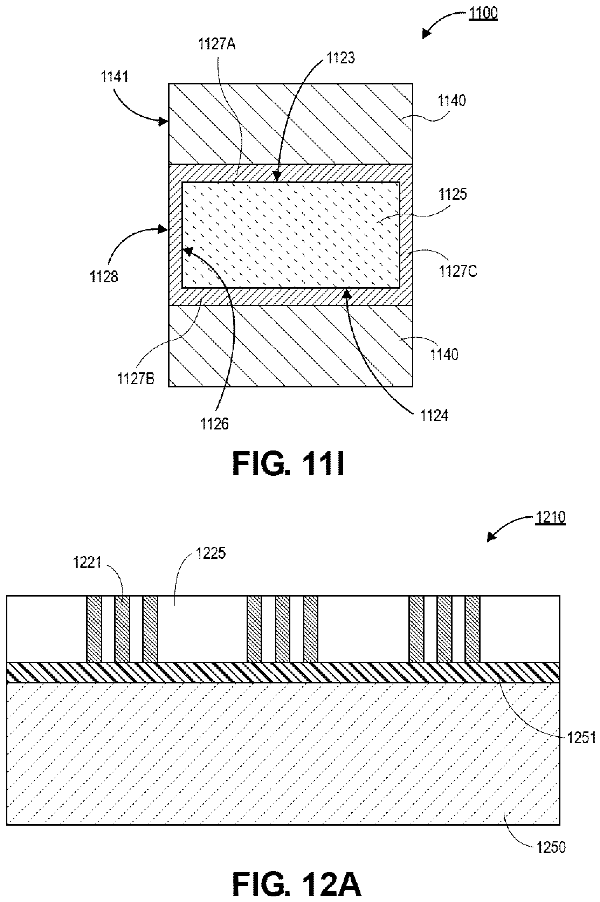

Referring now to Figures 11A - 11I, a series of illustrations depicting a process for forming a package substrate 1100 with a glass core 1125 is shown, in accordance with an embodiment. The package substrate 1100 is fabricated through a panel level process. More particularly, the panel level process includes the use of a glass frame. The glass frame may have substantially the same CTE as the glass cores, so there will be minimal warpage after reconstitution. Though, it is to be appreciated that the frame may comprise materials other than glass as well. For example, the frame may include a polymer, a polymer composite, or the like. Further, the stress due to CTE mismatch between the glass core and the overlying buildup material is proportional to length. In the reconstituted panels, the stress is limited to the length of the unit size, so the stress is reduced compared to an interface that has the full panel dimensions.

Referring now to Figure 11A, a plan view illustration of a panel 1110 is shown, in accordance with an embodiment. In an embodiment, the panel 1110 includes a frame 1180. The frame 1180 may be a glass frame. The glass formulation of the frame 1180 may be similar to or the same as the glass formulation for the glass cores used in the process flow. However, other materials may also be used for the frame 1180, such as, but not limited to, polymers, composites, and the like. The frame 1180 may include openings 1181. The openings 1181 may be sized to receive the glass cores in a subsequent processing operation. The openings 1181 may be oversized to accommodate the buffer layer around the glass cores. The openings 1181 may expose an underlying adhesive 1151 that is provided over a core 1150 (not visible in Figure 11A).

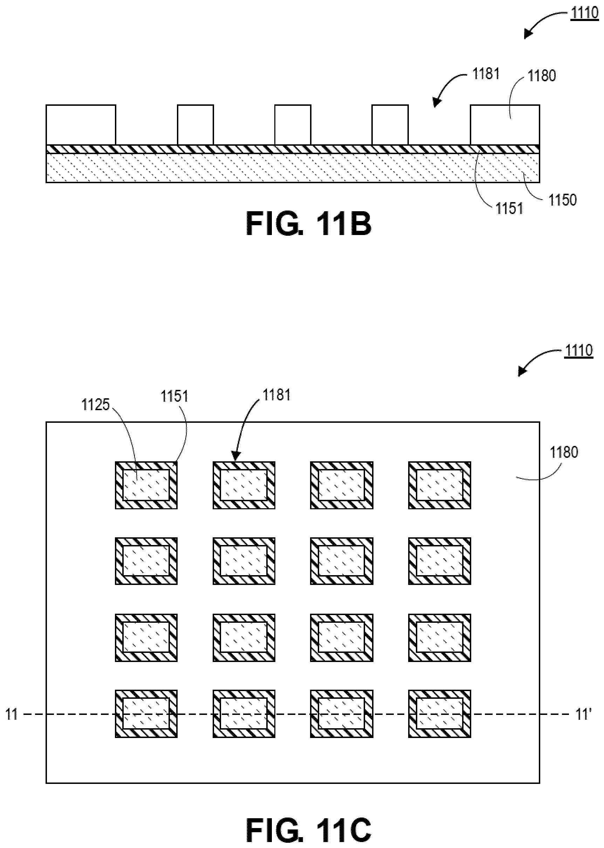

Referring now to Figure 11B, a cross-sectional illustration of the panel 1110 in Figure 11A along line 11-11' is shown, in accordance with an embodiment. The carrier 1150 below the adhesive layer 1151 may be any suitable material (e.g., glass, ceramic, metallic, etc.).

Referring now to Figure 11C, a plan view illustration of the panel 1110 after the glass cores 1125 are placed into the openings 1181 is shown, in accordance with an embodiment. The glass cores 1125 may be known-good units in order to provide improved process yield.

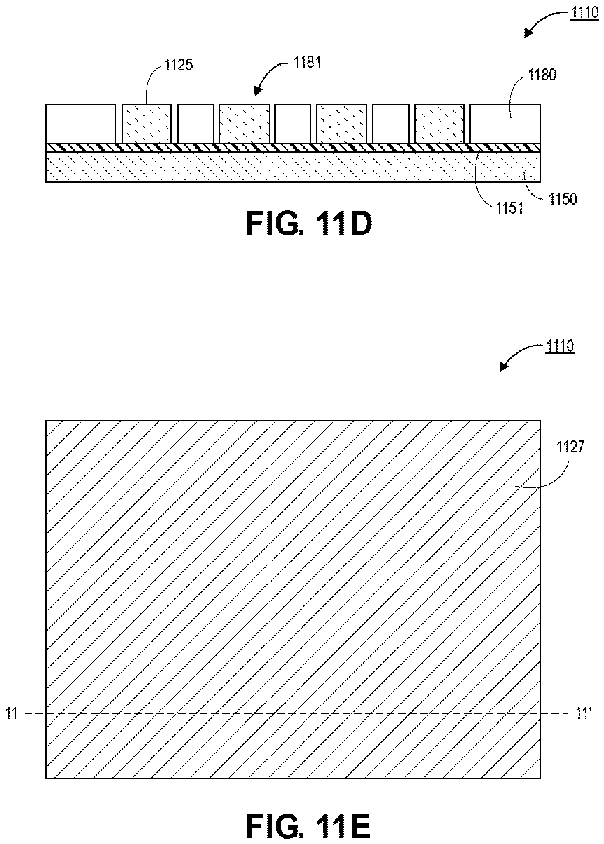

Referring now to Figure 11D, a cross-sectional illustration of the panel 1110 in Figure 11C along line 11-11' is shown, in accordance with an embodiment. As shown, the glass cores 1125 may have a thickness that is substantially equal to the thickness of the frame 1180. Though, the glass cores 1125 may also be thinner or thicker than the frame 1180. A width of the glass cores 1125 may be narrower than a width of the openings 1181. In the illustrated embodiment, the glass cores 1125 have substantially vertical sidewalls. Though, glass cores 1125 with tapered or non-vertical sidewalls may also be used in some embodiments. For simplicity, the glass cores 1125 are monolithic structures. In other embodiments, electrically conductive vias and the like may be fabricated in the glass cores 1125 before the glass cores 1125 are inserted into the frame 1180.

Referring now to Figure 11E, a plan view illustration of the panel 1110 after a buffer layer 1127 is applied is shown, in accordance with an embodiment. The buffer layer 1127 may be applied with any suitable deposition process. The buffer layer 1127 may be a material similar to any buffer layer material described in greater detail herein. In an embodiment, the buffer layer 1127 fills the remainder of the openings 1181 and covers a top surface of the frame 1180 and the glass cores 1125.

Referring now to Figure 11F, a cross-sectional illustration of the panel 1110 in Figure 11E along line 11-11' is shown, in accordance with an embodiment. As shown, the buffer layer 1127 conforms to the sidewall shape of the glass cores 1125 and fills the openings 1181. The buffer layer 1127 may cover the sidewalls of the glass cores 1125 as well as the top surface of the glass cores 1125.

Referring now to Figure 11G, a cross-sectional illustration of the panel 1110 after the carrier 1150 is removed is shown, in accordance with an embodiment. In an embodiment, an additional portion of the buffer layer 1127 can be applied over the bottom of the frame 1180 and the bottom of the glass cores 1125 after the carrier 1150 is removed. In an embodiment, the bottom portion of the buffer layer 1127 may have a thickness substantially equal to the thickness of the top portion of the buffer layer 1127 (i.e., the portion above the top surface of the glass cores 1125). In other embodiments, the bottom portion of the buffer layer 1127 may have a thickness that is different than the thickness of the top portion of the buffer layer 1127.

Referring now to Figure 11H, a cross-sectional illustration of the panel 1110 after buildup layers 1140 are provided above and/or below the frame 1180 and the glass cores 1125 is shown, in accordance with an embodiment. The buildup layers 1140 may comprise laminated organic buildup film material, or the like. Electrically conductive features (e.g., pads, traces, vias, etc.) may be provided within the buildup layers 1140. In an embodiment, saw streets 1105 may pass through the buildup layers 1140 and portions of the buffer layer 1127 between the glass cores 1125 and the frame 1180.

Referring now to Figure 111, a cross-sectional illustration of a package substrate 1100 after singulation is shown, in accordance with an embodiment. In an embodiment, the outer surface 1141 of the buildup layers 1140 is substantially coplanar with an outer surface 1128 of the buffer layer 1127. As shown, the buffer layer 1127 may be considered as being at least three different regions. A first region 1127A is provided above a top surface 1123 of the glass core 1125, a second region 1127B is provided below a bottom surface 1124 of the glass core 1125, and a third region 1127C is provided along the sidewall 1126 of the glass core 1125. In an embodiment, thicknesses of the different regions 1127A, 1127B, and 1127C may be substantially uniform to each other. In other embodiments, some or all of the different regions 1127A, 1127B, and 1127C may have different thicknesses.

Referring now to Figures 12A - 12G, a series of cross-sectional illustrations depicting a process for forming a package substrate 1200 with a panel level process is shown, in accordance with an embodiment.

Referring now to Figure 12A, a cross-sectional illustration of a panel 1210 is shown, in accordance with an embodiment. In an embodiment, the panel 1210 includes a glass sheet that includes a plurality of glass cores 1225. The glass cores 1225 may include electrically conductive vias 1221. The glass cores 1225 may be adhered to a carrier 1250 through an adhesive layer 1251. The carrier 1250 may comprise glass, ceramic, metal, or the like.

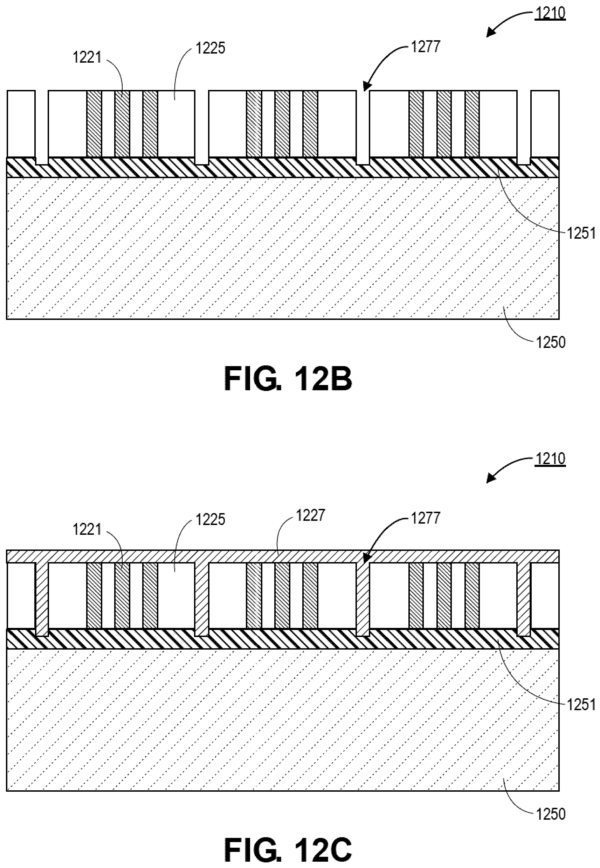

Referring now to Figure 12B, a cross-sectional illustration of the panel 1210 after trenches 1277 are formed between the glass cores 1225. In an embodiment, the trenches 1277 may be formed with a mechanical sawing process or any other suitable process. In some instances, the trenches 1277 may continue into the adhesive layer 1251.

Referring now to Figure 12C, a cross-sectional illustration of the panel 1210 after a buffer layer 1227 is dispensed around the glass cores 1225 is shown, in accordance with an embodiment. The buffer layer 1227 may include any material composition similar to other buffer layer structures described in greater detail herein. The buffer layer 1227 may be provided along sidewalls of the glass cores 1225 and over the top surfaces of the glass cores 1225.

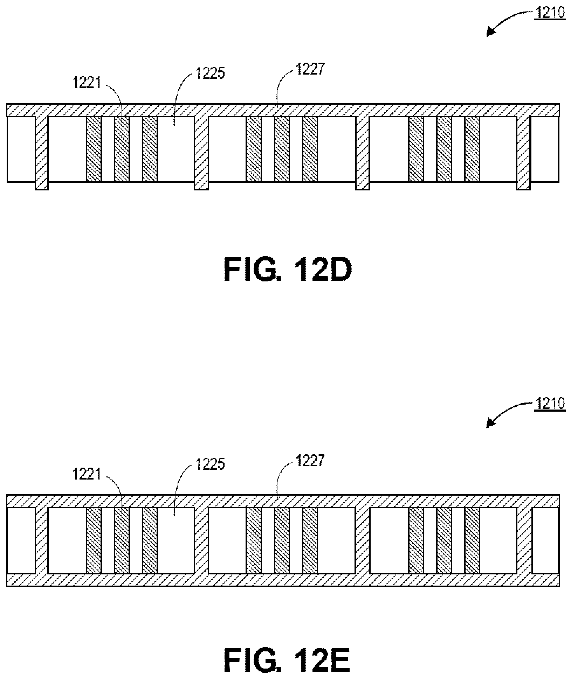

Referring now to Figure 12D, a cross-sectional illustration of the panel 1210 after the carrier 1250 is removed is shown, in accordance with an embodiment. In an embodiment, the carrier 1250 and adhesive 1251 may be removed with any suitable process. As shown, a small stem of the buffer layer 1227 may extend past a bottom surface of the glass cores 1225.

Referring now to Figure 12E, a cross-sectional illustration of the panel 1210 after an additional buffer layer 1227 portion is added. The additional portion of the buffer layer 1227 may be added along the bottom surfaces of the glass cores 1225. The bottom portion of the buffer layer 1227 may be the same material as the rest of the buffer layer 1227, or the bottom portion of the buffer layer 1227 may be a different material than the rest of the buffer layer 1227.

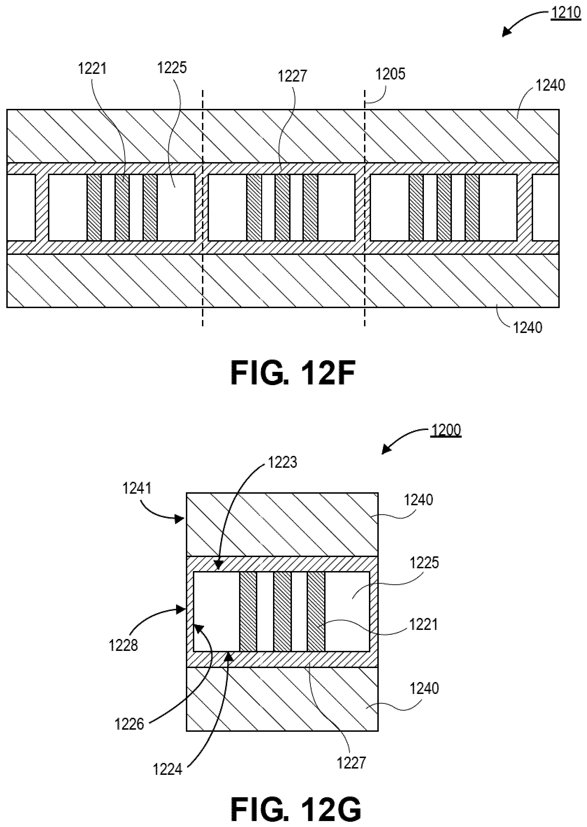

Referring now to Figure 12F, a cross-sectional illustration of the panel 1210 after buildup layers 1240 are provided over the buffer layer 1227 is shown, in accordance with an embodiment. In an embodiment, the buildup layers 1240 may include laminated organic buildup film or the like. Electrically conductive features (not shown) may also be embedded within the buildup layers 1240. As shown in Figure 12F, saw streets 1205 may be provided between the glass cores 1225. The saw streets 1205 may pass through the buildup layers 1240 and intersect a portion of the buffer layer 1227 between glass cores 1225.

Referring now to Figure 12G, a cross-sectional illustration of a package substrate 1200 after singulation is shown, in accordance with an embodiment. In an embodiment, the singulation process results in the sidewall 1241 of the buildup layers 1240 being substantially coplanar with an outer surface 1228 of the buffer layer 1227. Since the sidewall 1226 of the glass core 1225 is formed with a mechanical sawing process, the sidewall 1226 may also be substantially parallel to the edge 1228 of the buffer layer 1227.

In an embodiment, the buffer layer 1227 may entirely (or at least substantially) embed the glass core 1225. For example, the buffer layer 1227 may be provided over at least a portion of the top surface 1223 of the glass core 1225, at least a portion of the bottom surface 1224 of the glass core 1225, and at least a portion of the sidewall 1226 of the glass core 1225. In other embodiments, the buffer layer 1227 covers an entirety of one or more of the top surface 1223, the bottom surface 1224, or the sidewall 1226 of the glass core 1225. Additionally, the buffer layer 1227 may have different thicknesses over the different surfaces of the glass core 1225.

In an embodiment, any of the package substrates described herein may be used in an electronic system. For example, glass core packages substrates such as those described herein may be mechanically and electrically coupled to a board, such as a mother board. For example, second level interconnects (SLIs) such as solder or sockets may be used to couple the board to the glass core package substrate. In an embodiment, one or more dies may be coupled to the glass core package substrate by first level interconnects (FLIs), such as solder balls, copper bumps, hybrid bonding interfaces, or the like. The dies may include any suitable die architecture, such as a central processing unit (CPU), a graphics processing unit (GPU), an XPU, a communications die, a memory die, or the like.

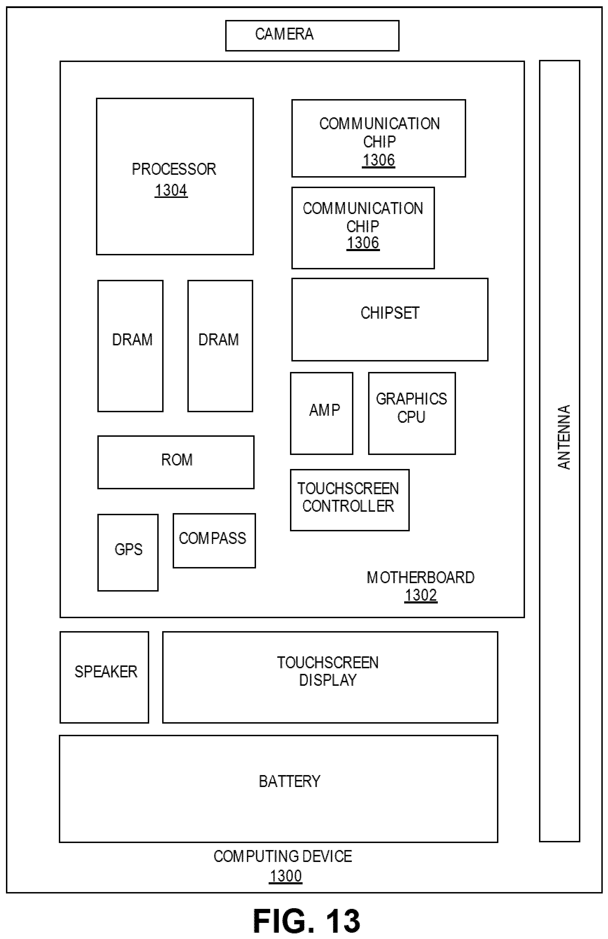

Figure 13 illustrates a computing device 1300 in accordance with one implementation of the disclosure. The computing device 1300 houses a board 1302. The board 1302 may include a number of components, including but not limited to a processor 1304 and at least one communication chip 1306. The processor 1304 is physically and electrically coupled to the board 1302. In some implementations the at least one communication chip 1306 is also physically and electrically coupled to the board 1302. In further implementations, the communication chip 1306 is part of the processor 1304.

These other components include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1306 enables wireless communications for the transfer of data to and from the computing device 1300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1306 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1300 may include a plurality of communication chips 1306. For instance, a first communication chip 1306 may be dedicated to shorter range wireless communications such as Wi-Fi and Bluetooth and a second communication chip 1306 may be dedicated to longer range wireless communications such as GPS, EDGE, GPRS, CDMA, WiMAX, LTE, Ev-DO, and others.

The processor 1304 of the computing device 1300 includes an integrated circuit die packaged within the processor 1304. In some implementations of the disclosure, the integrated circuit die of the processor may be part of an electronic package that includes a package substrate with a glass core and a buffer layer surrounding an outer perimeter of the glass core, in accordance with embodiments described herein. The term "processor" may refer to any device or portion of a device that processes electronic data from registers and/or memory to transform that electronic data into other electronic data that may be stored in registers and/or memory.

The communication chip 1306 also includes an integrated circuit die packaged within the communication chip 1306. In accordance with another implementation of the disclosure, the integrated circuit die of the communication chip may be part of an electronic package that includes a package substrate with a glass core and a buffer layer surrounding an outer perimeter of the glass core, in accordance with embodiments described herein.

In an embodiment, the computing device 1300 may be part of any apparatus. For example, the computing device may be part of a personal computer, a server, a mobile device, a tablet, an automobile, or the like. That is, the computing device 1300 is not limited to being used for any particular type of system, and the computing device 1300 may be included in any apparatus that may benefit from computing functionality.

## Claims

1. An apparatus, comprising:
a substrate with a first surface (223, 224), a second surface (224, 223) opposite from the first surface (223, 224), and a sidewall between the first surface (223, 224) and the second surface (224, 223), wherein the substrate comprises a glass layer (225, 925);
a via (221) through the substrate between the first surface (223, 224) and the second surface (224, 223), wherein the via (221) is electrically conductive; and
a layer (227, 927) in contact with the sidewall of the substrate, wherein the layer (227, 927) surrounds a perimeter of the substrate, wherein
a notch (233, 933) is provided in the first surface (223, 224), and the layer (227, 927) fills the notch (233, 933).

2. The apparatus of claim 1, wherein the layer also contacts the first surface and/or the second surface.

3. The apparatus of claim 1 or 2, wherein at least a portion of the sidewall is oriented to the first surface at a non-orthogonal angle.

4. The apparatus of claim 3, wherein the layer has an outer surface that is substantially orthogonal to the first surface and an inner surface that conforms to a profile of the sidewall of the substrate.

5. The apparatus of claim 1, 2, 3 or 4, further comprising:
a third surface surrounding a perimeter of the first surface, wherein the third surface is recessed below the first surface; and
wherein the layer further contacts the third surface.

6. The apparatus of claim 5, wherein:
the notch is provided into the third surface.

7. The apparatus of claim 1, 2, 3, 4, 5 or 6, wherein the layer comprises an organic material.

8. The apparatus of claim 7, wherein the layer comprises a material compatible with molding or wherein the layer comprises a buildup film.

9. The apparatus of claim 1, 2, 3, 4, 5, 6, 7 or 8, wherein a thickness of the layer between an outer surface of the layer and the sidewall of the substrate is up to approximately 200µm.

10. The apparatus of claim 1, 2, 3, 4, 5, 6, 7, 8 or 9, wherein the substrate has a thickness between approximately 100µm and approximately 2,000µm.

11. A method, comprising:
providing a substrate with a first surface (223, 224), a second surface (224, 223) opposite from the first surface (223, 224), and a sidewall between the first surface (223, 224) and the second surface (224, 223), wherein the substrate comprises a glass layer (225, 925);
forming a via (221) through the substrate between the first surface (223, 224) and the second surface (224, 223), wherein the via (221) is electrically conductive; and
forming a layer (227, 927) in contact with the sidewall of the substrate, wherein the layer (227, 927) surrounds a perimeter of the substrate, wherein
a notch (233, 933) is provided in the first surface (223, 224), and the layer (227, 927) fills the notch (233, 933).

12. The method of claim 11, wherein the layer also contacts the first surface and/or the second surface.

13. The method of claim 11 or 12, wherein at least a portion of the sidewall is oriented to the first surface at a non-orthogonal angle.

14. The method of claim 13, wherein the layer has an outer surface that is substantially orthogonal to the first surface and an inner surface that conforms to a profile of the sidewall of the substrate.

15. The method of claim 11, 12, 13 or 14, further comprising:
providing a third surface surrounding a perimeter of the first surface, wherein the third surface is recessed below the first surface; and
wherein the layer further contacts the third surface.

## Patentansprüche

1. Einrichtung, die Folgendes umfasst:
ein Substrat mit einer ersten Oberfläche (223, 224), einer zweiten Oberfläche (224, 223) gegenüber der ersten Oberfläche (223, 224) und einer Seitenwand zwischen der ersten Oberfläche (223, 224) und der zweiten Oberfläche (224, 223), wobei das Substrat eine Glasschicht (225, 925) umfasst;
ein Via (221) durch das Substrat zwischen der ersten Oberfläche (223, 224) und der zweiten Oberfläche (224, 223), wobei das Via (221) elektrisch leitfähig ist; und eine Schicht (227, 927) in Kontakt mit der Seitenwand des Substrats, wobei die Schicht (227, 927) einen Umfang des Substrats umgibt, wobei
eine Einkerbung (233, 933) in der ersten Oberfläche (223, 224) bereitgestellt ist und die Schicht (227, 927) die Einkerbung (233, 933) ausfüllt.

2. Einrichtung nach Anspruch 1, wobei die Schicht auch mit der ersten Oberfläche und/oder der zweiten Oberfläche in Kontakt steht.

3. Einrichtung nach Anspruch 1 oder 2, wobei mindestens ein Teil der Seitenwand in einem nicht-orthogonalen Winkel zu der ersten Oberfläche ausgerichtet ist.

4. Einrichtung nach Anspruch 3, wobei die Schicht eine Außenfläche, die im Wesentlichen orthogonal zu der ersten Oberfläche ist, und eine Innenfläche, die konform zu einem Profil der Seitenwand des Substrats ist, aufweist.

5. Einrichtung nach Anspruch 1, 2, 3 oder 4, die ferner Folgendes umfasst:
eine dritte Oberfläche, die einen Umfang der ersten Oberfläche umgibt, wobei die dritte Oberfläche unterhalb der ersten Oberfläche vertieft ist; und
wobei die Schicht ferner mit der dritten Oberfläche in Kontakt steht.

6. Einrichtung nach Anspruch 5, wobei:
die Einkerbung in der dritten Fläche bereitgestellt ist.

7. Einrichtung nach Anspruch 1, 2, 3, 4, 5 oder 6, wobei die Schicht ein organisches Material umfasst.

8. Einrichtung nach Anspruch 7, wobei die Schicht ein mit einem Formen kompatibles Material umfasst oder wobei die Schicht einen Aufbaufilm umfasst.

9. Einrichtung nach Anspruch 1, 2, 3, 4, 5, 6, 7 oder 8, wobei eine Dicke der Schicht zwischen einer Außenfläche der Schicht und der Seitenwand des Substrats bis zu etwa 200 µm beträgt.

10. Einrichtung nach Anspruch 1, 2, 3, 4, 5, 6, 7, 8 oder 9, wobei das Substrat eine Dicke zwischen etwa 100 µm und etwa 2.000 µm aufweist.

11. Verfahren, das Folgendes umfasst:
Bereitstellen eines Substrats mit einer ersten Oberfläche (223, 224), einer zweiten Oberfläche (224, 223) gegenüber der ersten Oberfläche (223, 224) und einer Seitenwand zwischen der ersten Oberfläche (223, 224) und der zweiten Oberfläche (224, 223), wobei das Substrat eine Glasschicht (225, 925) umfasst;
Bilden eines Vias (221) durch das Substrat zwischen der ersten Oberfläche (223, 224) und der zweiten Oberfläche (224, 223), wobei das Via (221) elektrisch leitfähig ist; und
Bilden einer Schicht (227, 927) in Kontakt mit der Seitenwand des Substrats, wobei die Schicht (227, 927) einen Umfang des Substrats umgibt, wobei eine Einkerbung (233, 933) in der ersten Oberfläche (223, 224) bereitgestellt ist und die Schicht (227, 927) die Einkerbung (233, 933) ausfüllt.

12. Verfahren nach Anspruch 11, wobei die Schicht auch mit der ersten Oberfläche und/oder der zweiten Oberfläche in Kontakt steht.

13. Verfahren nach Anspruch 11 oder 12, wobei mindestens ein Teil der Seitenwand in einem nicht-orthogonalen Winkel zu der ersten Oberfläche ausgerichtet ist.

14. Verfahren nach Anspruch 13, wobei die Schicht eine Außenfläche, die im Wesentlichen orthogonal zu der ersten Oberfläche ist, und eine Innenfläche, die konform zu einem Profil der Seitenwand des Substrats ist, aufweist.

15. Verfahren nach Anspruch 11, 12, 13 oder 14, das ferner Folgendes umfasst:
Bereitstellen einer dritten Oberfläche, die einen Umfang der ersten Oberfläche umgibt, wobei die dritte Oberfläche unterhalb der ersten Oberfläche vertieft ist; und
wobei die Schicht ferner mit der dritten Oberfläche in Kontakt steht.

## Revendications

1. Appareil, comprenant :
un substrat avec une première surface (223, 224), une deuxième surface (224, 223) opposée à la première surface (223, 224), et une paroi latérale entre la première surface (223, 224) et la deuxième surface (224, 223), le substrat comprenant une couche (225, 925) de verre ;
un trou (221) d'interconnexion traversant le substrat entre la première surface (223, 224) et la deuxième surface (224, 223), le trou (221) d'interconnexion étant électriquement conducteur ; et
une couche (227, 927) en contact avec la paroi latérale du substrat, la couche (227, 927) entourant un périmètre du substrat,
une encoche (233, 933) étant pratiquée dans la première surface (223, 224) et la couche (227, 927) remplissant l'encoche (233, 933).

2. Appareil selon la revendication 1, la couche étant également en contact avec la première surface et/ou la deuxième surface.

3. Appareil selon la revendication 1 ou 2, au moins une partie de la paroi latérale étant orientée par rapport à la première surface selon un angle non orthogonal.

4. Appareil selon la revendication 3, la couche présentant une surface extérieure qui est sensiblement orthogonale à la première surface et une surface intérieure qui se conforme à un profil de la paroi latérale du substrat.

5. Appareil selon la revendication 1, 2, 3 ou 4, comprenant en outre :
une troisième surface entourant un périmètre de la première surface, la troisième surface étant en retrait au-dessous de la première surface ; et
la couche étant en outre en contact avec la troisième surface.

6. Appareil de la revendication 5, dans lequel :
l'encoche est pratiquée dans la troisième surface.

7. Appareil selon la revendication 1, 2, 3, 4, 5 ou 6, la couche comprenant un matériau organique.

8. Appareil selon la revendication 7, la couche comprenant un matériau compatible avec le moulage ou la couche comprenant un film d'accumulation.

9. Appareil selon la revendication 1, 2, 3, 4, 5, 6, 7 ou 8, une épaisseur de la couche entre une surface extérieure de la couche et la paroi latérale du substrat allant jusqu'à environ 200µm.

10. Appareil selon la revendication 1, 2, 3, 4, 5, 6, 7, 8 ou 9, le substrat présentant une épaisseur comprise entre environ 100µm et environ 2 000µm.

11. Procédé, comprenant :
la mise en place d'un substrat avec une première surface (223, 224), une deuxième surface (224, 223) opposée à la première surface (223, 224), et une paroi latérale entre la première surface (223, 224) et la deuxième surface (224, 223), le substrat comprenant une couche (225, 925) de verre ;
la formation d'un trou (221) d'interconnexion à travers le substrat entre la première surface (223, 224) et la deuxième surface (224, 223), le trou (221) d'interconnexion étant électriquement conducteur ; et
la formation d'une couche (227, 927) en contact avec la paroi latérale du substrat, la couche (227, 927) entourant un périmètre du substrat,
une encoche (233, 933) étant pratiquée dans la première surface (223, 224) et la couche (227, 927) remplissant l'encoche (233, 933).

12. Procédé selon la revendication 11, la couche étant également en contact avec la première surface et/ou la deuxième surface.

13. Procédé selon la revendication 11 ou 12, au moins une partie de la paroi latérale étant orientée par rapport à la première surface selon un angle non orthogonal.

14. Procédé selon la revendication 13, la couche présentant une surface extérieure qui est sensiblement orthogonale à la première surface et une surface intérieure qui se conforme à un profil de la paroi latérale du substrat.

15. Procédé selon les revendications 11, 12, 13 ou 14, comprenant en outre :
la mise en place d'une troisième surface entourant un périmètre de la première surface, la troisième surface étant en retrait au-dessous de la première surface ; et
la couche étant en outre en contact avec la troisième surface.
